# EUROPEAN PATENT SPECIFICATION

(11) **EP 4 525 590 B1**
(45) Date of publication and mention of the grant of the patent: **24.06.2026**
(21) Application number: 24199086.0
(22) Date of filing: 06.09.2024
(51) Int. Cl.: H10K 59/122, H10K 59/80, H10K 102/00

(54) **DISPLAY DEVICE AND METHOD OF MANUFACTURING THE DISPLAY DEVICE**
ANZEIGEVORRICHTUNG UND VERFAHREN ZUR HERSTELLUNG DER ANZEIGEVORRICHTUNG
DISPOSITIF D'AFFICHAGE ET PROCÉDÉ DE FABRICATION DU DISPOSITIF D'AFFICHAGE

(30) Priority: 12.09.2023 KR 20230121018
(43) Date of publication of application: 19.03.2025
(73) Proprietor: Samsung Display Co., Ltd., Gyeonggi-Do (KR)
(72) Inventor: PARK, Joonyong, Yongin-si (KR); YANG, Sukyoung, Yongin-si (KR); LEE, Dongmin, Yongin-si (KR); SHIN, Hyuneok, Yongin-si (KR)
(74) Representative: Marks & Clerk LLP

(56) References cited:
- WO-A1-2022/097043
- US-A1- 2023 269 969
- US-B2- 10 700 304

## Description

### BACKGROUND

### Field

Embodiments of the present disclosure described herein relate to a display device and a method of manufacturing a display device, and more particularly, relate to a display device including an auxiliary electrode and a method for manufacturing the display device.

### Description of the Related Art

Display devices, such as, for example, a television, a monitor, a smart phone, a tablet computer, and the like, which provide an image to a user include a display panel that displays an image. Various display panels, such as, for example, a liquid crystal display panel, an organic light emitting display panel, an electro wetting display panel, an electrophoretic display panel, and the like, are being developed. Display devices have been disclosed in WO 2022/097043 A1, US 2023/269969 A1 and US 10 700 304 B2.

The organic light emitting display panel may include anodes, cathodes, and emission patterns. The emission patterns may be separated for respective emissive regions, and the cathodes may provide a common voltage to the respective emissive regions.

### SUMMARY

Embodiments of the present disclosure provide a display device for increasing light transmittances of respective emissive regions and a method for manufacturing the display device.

According to an embodiment, a display device includes a base layer including first to third emissive regions, a pixel defining layer that is disposed on the base layer, where first to third light emitting openings defined in the pixel defining layer overlap the first to third emissive regions, respectively, a barrier wall that includes a first barrier wall layer disposed on the pixel defining layer and a second barrier wall layer disposed on the first barrier wall layer, where first to third barrier wall openings defined in the barrier wall overlap the first to third light emitting openings, respectively, light emitting elements, each of which includes a first electrode, an intermediate layer disposed on the first electrode, and a second electrode disposed on the intermediate layer, and auxiliary electrodes that are disposed on the light emitting elements and that cover the second electrodes. The auxiliary electrodes include a first auxiliary electrode that overlaps the first light emitting opening and has a first thickness, a second auxiliary electrode that overlaps the second light emitting opening and has a second thickness different from the first thickness, and a third auxiliary electrode that overlaps the third light emitting opening and has a third thickness different from the first thickness and the second thickness.

The second barrier wall layer may include a first tip portion that protrudes from the first barrier wall layer toward the first barrier wall opening by a first protruding length, a second tip portion that protrudes from the first barrier wall layer toward the second barrier wall opening by a second protruding length different from the first protruding length, and a third tip portion that protrudes from the first barrier wall layer toward the third barrier wall opening by a third protruding length different from the first protruding length and the second protruding length.

The first thickness may be proportional to the first protruding length, the second thickness may be proportional to the second protruding length, and the third thickness may be proportional to the third protruding length.

The light emitting elements may include a first light emitting element that overlaps the first light emitting opening, a second light emitting element that overlaps the second light emitting opening, and a third light emitting element that overlaps the third light emitting opening. The first light emitting element may emit red light, the second light emitting element may emit green light, and the third light emitting element may emit blue light.

The third thickness may be greater than the first thickness, and the second thickness may be greater than the third thickness.

The third protruding length may be longer than the first protruding length, and the second protruding length may be longer than the third protruding length.

The first thickness may range from about 255 Å to about 345 Å.

The second thickness may range from about 1020 Å to about 1380 Å.

The third thickness may range from about 765 Å to about 1035 Å.

The first protruding length may range from about 0.4 µm to about 0.5 µm.

The second protruding length may range from about 1.5 µm to about 1.8 µm.

The third protruding length may range from about 1.0 µm to about 1.4 µm.

The first auxiliary electrode may not make contact with at least a portion of a lower surface of the first tip portion, the second auxiliary electrode may not make contact with at least a portion of a lower surface of the second tip portion, and the third auxiliary electrode may not make contact with at least a portion of a lower surface of the third tip portion.

The first to third auxiliary electrodes may be electrically connected with the barrier wall and make contact with inner surfaces of the first barrier wall layer, respectively.

Each of the first to third auxiliary electrodes may include indium zinc oxide.

The first thickness may be a thickness by which red light transmittance of the first auxiliary electrode is maximal, the second thickness may be a thickness by which green light transmittance of the second auxiliary electrode is maximal, and the third thickness may be a thickness by which blue light transmittance of the third auxiliary electrode is maximal.

A thickness of the second barrier wall layer may range from about 2500 Å to about 3000 Å.

The display device may further include first to third capping patterns that are disposed on the first to third auxiliary electrodes and that overlap the first to third light emitting openings, respectively.

According to an embodiment, a display device includes a base layer including first to third emissive regions, a pixel defining layer that is disposed on the base layer, where first to third light emitting openings defined in the pixel defining layer overlap the first to third emissive regions, respectively, a barrier wall that includes a first barrier wall layer disposed on the pixel defining layer and a second barrier wall layer disposed on the first barrier wall layer, where first to third barrier wall openings defined in the barrier wall overlap the first to third light emitting openings, respectively, light emitting elements, each of which includes a first electrode, an intermediate layer disposed on the first electrode, and a second electrode disposed on the intermediate layer, and auxiliary electrodes that are disposed on the light emitting elements and that cover the second electrodes. The second barrier wall layer includes a first tip portion that protrudes from the first barrier wall layer toward the first barrier wall opening by a first protruding length, a second tip portion that protrudes from the first barrier wall layer toward the second barrier wall opening by a second protruding length different from the first protruding length, and a third tip portion that protrudes from the first barrier wall layer toward the third barrier wall opening by a third protruding length different from the first protruding length and the second protruding length.

According to an embodiment, a method for manufacturing a display device includes providing a preliminary display panel including a base layer, a pixel defining layer disposed on the base layer, a first preliminary barrier wall layer disposed on the pixel defining layer, and a second preliminary barrier wall layer disposed on the first preliminary barrier wall layer, forming a first barrier wall opening and a first tip portion of the second preliminary barrier wall layer by etching the first preliminary barrier wall layer and the second preliminary barrier wall layer, where the first tip portion protrudes from the first preliminary barrier wall layer toward the first barrier wall opening, forming, in the first barrier wall opening, a first light emitting element and a first auxiliary electrode that is disposed on the first light emitting element and that has a first thickness, forming a second barrier wall opening and a second tip portion of the second preliminary barrier wall layer by etching the first preliminary barrier wall layer and the second preliminary barrier wall layer, where the second tip portion protrudes from the first preliminary barrier wall layer toward the second barrier wall opening, and forming, in the second barrier wall opening, a second light emitting element and a second auxiliary electrode that is disposed on the second light emitting element and that has a second thickness different from the first thickness. The first thickness is proportional to a protruding length of the first tip portion, and the second thickness is proportional to a protruding length of the second tip portion.

The method may further include forming a third barrier wall opening and a third tip portion of the second preliminary barrier wall layer by etching the first preliminary barrier wall layer and the second preliminary barrier wall layer, where the third tip portion that protrudes from the first preliminary barrier wall layer toward the third barrier wall opening, and forming, in the third barrier wall opening, a third light emitting element and a third auxiliary electrode that is disposed on the third light emitting element and that has a third thickness different from the first thickness and the second thickness. The third thickness may be proportional to a protruding length of the third tip portion.

An emission pattern and a cathode of each of the first light emitting element and the second light emitting element may be formed through a thermal evaporation process, and each of the first auxiliary electrode and the second auxiliary electrode may be formed through a sputtering process.

The forming of the first barrier wall opening and the first tip portion may include performing a first dry etching process on the first preliminary barrier wall layer and the second preliminary barrier wall layer and performing a first wet etching process on the second preliminary barrier wall layer. The forming of the second barrier wall opening and the second tip portion may include performing a second dry etching process on the first preliminary barrier wall layer and the second preliminary barrier wall layer and performing a second wet etching process on the second preliminary barrier wall layer. A time period during which the second preliminary barrier wall layer is exposed to an etchant in the first wet etching process may be different from a time period during which the second preliminary barrier wall layer is exposed to an etchant in the second wet etching process.

At least some of the above and other features of the invention are set out in the claims.

### BRIEF DESCRIPTION OF THE DRAWINGS

The above and other objects and features of the present disclosure will become apparent by describing in detail embodiments thereof with reference to the accompanying drawings.
FIG. 1 is a perspective view of a display device according to an embodiment of the present disclosure.
FIG. 2 is an exploded perspective view of the display device according to an embodiment of the present disclosure.
FIG. 3 is a sectional view of a display module according to an embodiment of the present disclosure.
FIG. 4 is a plan view of a display panel according to an embodiment of the present disclosure.
FIG. 5 is an equivalent circuit diagram of a pixel according to an embodiment of the present disclosure.
FIG. 6 is an enlarged plan view of a portion of a display region of the display panel according to an embodiment of the present disclosure.
FIG. 7 is a sectional view of the display panel taken along line I-I' of FIG. 4 according to an embodiment of the present disclosure.
FIG. 8 is an enlarged view illustrating region AA' of FIG. 7 according to an embodiment of the present disclosure.
FIG. 9 is a sectional view taken along line II-II' of FIG. 6 according to an embodiment of the present disclosure.
FIG. 10A is an enlarged sectional view illustrating a first emissive region of FIG. 9 according to an embodiment of the present disclosure.
FIG. 10B is an enlarged sectional view illustrating a second emissive region of FIG. 9 according to an embodiment of the present disclosure.
FIG. 10C is an enlarged sectional view illustrating a third emissive region of FIG. 9 according to an embodiment of the present disclosure.
FIG. 11 is a sectional view of a display panel taken along line I-I' of FIG. 4 according to an embodiment of the present disclosure.
FIGS. 12A to 12H are sectional views illustrating some of the steps of a method of manufacturing a display device according to an embodiment of the present disclosure.
FIGS. 13A to 13E are sectional views illustrating some of the steps of the method of manufacturing a display device according to an embodiment of the present disclosure.
FIGS. 14A to 14C are sectional views illustrating some of the steps of the method of manufacturing a display device according to an embodiment of the present disclosure.

### DETAILED DESCRIPTION

In this specification, when it is described that a component (or, an area, a layer, a part, or the like) is referred to as being "on", "connected to" or "coupled to" another component, this means that the component may be directly on, connected to, or coupled to the other component or a third component may be present between the component and the other component.

Identical reference numerals refer to identical components. Additionally, in the drawings, the thicknesses, proportions, and dimensions of components are exaggerated for effective description. As used herein, the term "and/or" includes all of one or more combinations defined by related components.

Terms such as, for example, first, second, and the like may be used to describe various components, but the components should not be limited by the terms. The terms as used herein may distinguish one component from other components. For example, without departing the scope of the present disclosure, a first component may be referred to as a second component, and similarly, the second component may also be referred to as the first component. The terms of a singular form may include plural forms unless otherwise specified.

In some aspects, terms such as, for example, "below", "under", "above", and "over" are used to describe a relationship of components illustrated in the drawings. The terms are relative concepts and are described based on directions illustrated in the drawing.

It should be understood that terms such as, for example, "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

The terms "about" or "approximately" as used herein are inclusive of the stated value and include a suitable range of deviation for the particular value as determined by one of ordinary skill in the art, considering the measurement in question and the error associated with measurement of the particular quantity. The term "about" can mean within one or more standard deviations, or within ± 30%, 20%, 10%, 5% of the stated value, for example.

Relative terms such as, for example, "large," "small," "long," "short," and the like with reference to an element may refer to a relative size of the element compared to another element. Relative terms such as, for example, "large," "small," "long," "short," "greatly," and the like with reference to a characteristic of an element may refer to a relative value of the characteristic compared to a threshold value. The term "substantially," as used herein, means approximately or actually. The term "substantially equal," as used herein, means approximately or actually equal (e.g., within a threshold percent of equal). The term "substantially the same," as used herein, means approximately or actually the same (e.g., within a threshold difference amount).

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, embodiments of the present disclosure will be described with reference to the accompanying drawings.

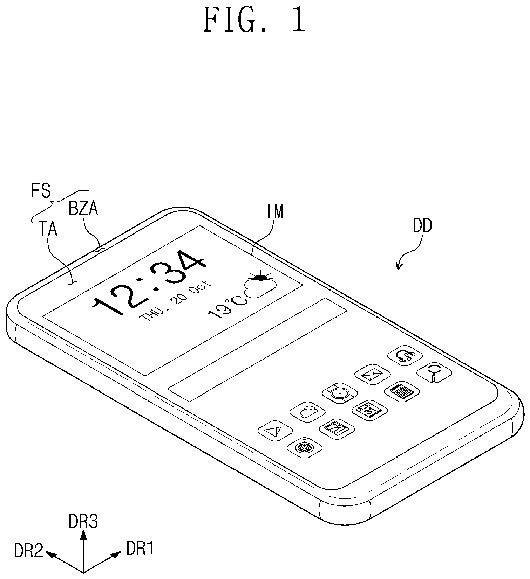

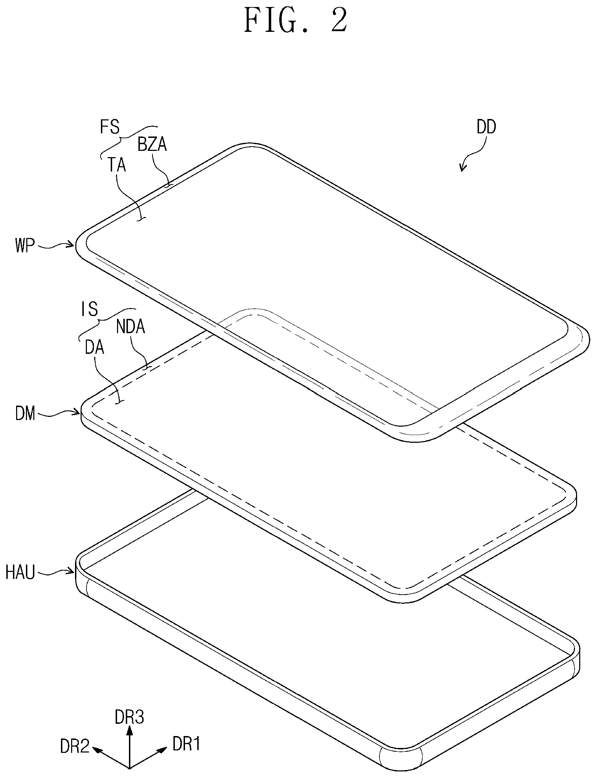

FIG. 1 is a perspective view of a display device according to an embodiment of the present disclosure. FIG. 2 is an exploded perspective view of the display device according to an embodiment of the present disclosure.

In an embodiment, the display device DD may be a large electronic device such as, for example, a television, a monitor, or a billboard. Alternatively, the display device DD may be a small and medium-sized electronic device such as, for example, a personal computer, a notebook computer, a personal digital terminal, a car navigation unit, a game machine, a smart phone, a tablet computer, or a camera. However, this is illustrative, and the display device DD may be employed as other display devices without departing from the scope of the present disclosure. In the examples described with reference to FIGS. 1 and 2, the display device DD is a smart phone.

Referring to FIGS. 1 and 2, the display device DD may display an image IM in a third direction DR3 on a display surface FS parallel to a first direction DR1 and a second direction DR2. The third direction DR3 may be a normal direction of a plane defined by the first direction DR1 and the second direction DR2. The image IM may include a still image as well as a dynamic image. In FIG. 1, a clock window and icons are illustrated as examples of the image IM. The display surface FS on which the image IM is displayed may correspond to the front surface of the display device DD.

In this example embodiment, front surfaces (or, upper surfaces) and rear surfaces (or, lower surfaces) of members are defined based on the direction in which the image IM is displayed. The front surfaces and the rear surfaces may face away from each other in the third direction DR3, and the normal directions of the front surfaces and the rear surfaces may be parallel to the third direction DR3. In some embodiments, the directions indicated by the first to third directions DR1, DR2, and DR3 may be relative concepts and may be changed to other directions. As used herein, the expression "when viewed from above the plane" may mean viewing in the third direction DR3.

The display device DD may include a window WP, a display module DM, and a housing HAU. The window WP and the housing HAU may be coupled with each other to form the exterior of the display device DD.

The window WP may include an optically clear insulating material. For example, the window WP may include glass or plastic. The front surface of the window WP may define the display surface FS of the display device DD. The display surface FS may include a transmission region TA and a bezel region BZA. The transmission region TA may be an optically clear region. For example, the transmission region TA may be a region having a visible light transmittance of about 90% or more.

The bezel region BZA may be a region having a lower light transmittance than the transmission region TA. The bezel region BZA may define the shape of the transmission region TA. The bezel region BZA may be adjacent to the transmission region TA and may surround the transmission region TA. However, this is illustrative, and the bezel region BZA of the window WP may be omitted. The window WP may include at least one of an anti-fingerprint layer, a hard coating layer, and an anti-reflection layer and is not limited to any one embodiment.

The display module DM may be disposed under the window WP. The display module DM may be a component that substantially generates the image IM. The image IM generated by the display module DM is displayed on a display surface IS of the display module DM and visually recognized by a user from the outside through the transmission region TA.

The display module DM may include a display region DA and a non-display region NDA. The display region DA may be a region activated based on an electrical signal. The non-display region NDA may be adjacent to the display region DA. The non-display region NDA may surround the display region DA. The non-display region NDA may be a region covered by the bezel region BZA and may not be visible from the outside.

The housing HAU may be coupled with the window WP. The housing HAU may be coupled with the window WP and provide an inner space. The display module DM may be accommodated in the inner space.

The housing HAU may include a material having a relatively high rigidity. For example, the housing HAU may include glass, plastic, or metal, or may include a plurality of frames and/or plates formed of a combination of the aforementioned materials. The housing HAU may stably protect components of the display device DD accommodated in the inner space from external impact.

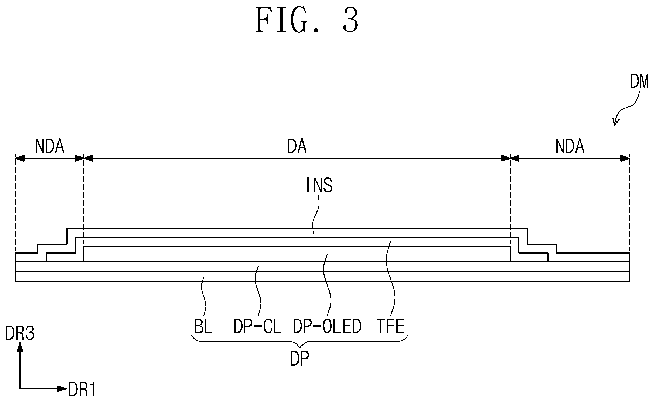

FIG. 3 is a sectional view of the display module according to an embodiment of the present disclosure.

Referring to FIG. 3, the display module DM may include a display panel DP and an input sensor INS. Although not separately illustrated, the display device DD (refer to FIG. 1) according to an embodiment of the present disclosure may further include a protective member disposed on the lower surface of the display panel DP or an anti-reflection member and/or a window member disposed on the upper surface of the input sensor INS.

The display panel DP may be an emissive display panel. However, this is illustrative, and the present disclosure is not particularly limited thereto. For example, the display panel DP may be an organic light emitting display panel or an inorganic light emitting display panel. An emissive layer in the organic light emitting display panel may include an organic luminescent material. An emissive layer in the inorganic light emitting display panel may include quantum dots, quantum rods, or micro LEDs. Hereinafter, in the examples described herein, the display panel DP is an organic light emitting display panel.

The display panel DP may include a base layer BL, and a circuit element layer DP-CL, a display element layer DP-OLED, and a thin film encapsulation layer TFE that are disposed on the base layer BL. The input sensor INS may be directly disposed on the thin film encapsulation layer TFE. As used herein, the expression "component A is directly disposed on component B" means that an adhesive layer is not disposed between component A and component B.

The base layer BL may include at least one plastic film. The base layer BL may be a flexible substrate and may include a plastic substrate, a glass substrate, a metal substrate, or an organic/inorganic composite substrate. The display region DA and the non-display region NDA described herein with reference to FIG. 2 may be identically defined in the base layer BL.

The circuit element layer DP-CL may include at least one insulating layer and a circuit element. The insulating layer may include at least one inorganic layer and at least one organic layer. The circuit element includes signal lines and a pixel drive circuit.

The display element layer DP-OLED may include barrier walls and light emitting elements. Each of the light emitting elements may include an anode, an intermediate layer, and a cathode.

The thin film encapsulation layer TFE may include a plurality of thin films. Some of the thin films may be disposed to improve optical efficiency, and the other thin films may be disposed to protect the light emitting elements.

The input sensor INS obtains coordinate information of an external input. The input sensor INS may have a multi-layer structure. The input sensor INS may include a single conductive layer or multiple conductive layers. Furthermore, the input sensor INS may include a single insulating layer or multiple insulating layers. The input sensor INS may sense the external input in a capacitive type. However, this is illustrative, and embodiments of the present disclosure are not limited thereto. For example, in an embodiment, the input sensor INS may sense the external input using an electromagnetic induction method or a pressure sensing method. In some other embodiments of the present disclosure, the input sensor INS may be omitted.

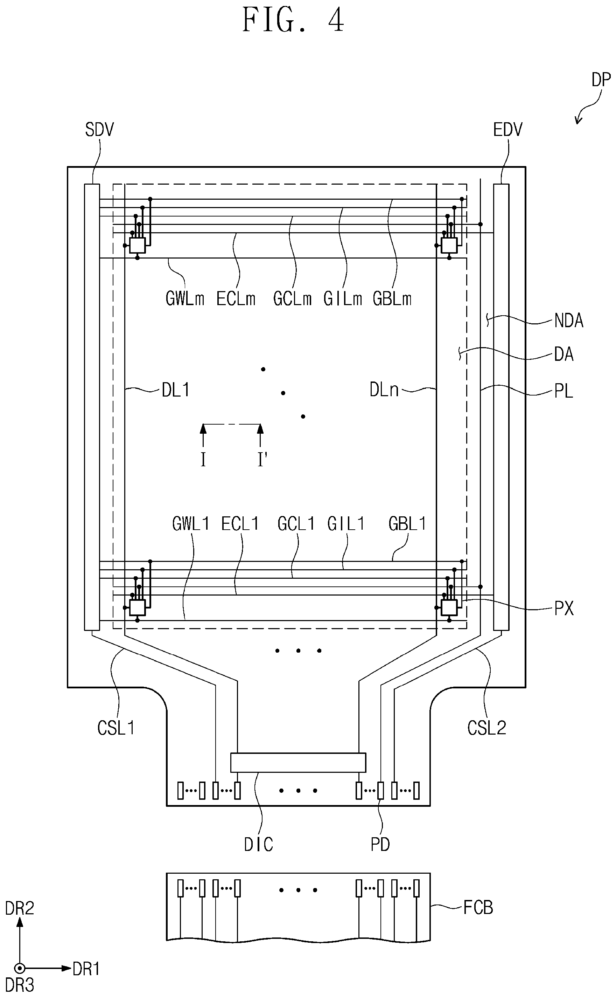

FIG. 4 is a plan view of the display panel according to an embodiment of the present disclosure.

Referring to FIG. 4, the display region DA and the non-display region NDA around the display region DA may be defined in the display panel DP. The display region DA and the non-display region NDA may be distinguished from each other based on whether pixels PX are disposed. The pixels PX may be disposed in the display region DA and may not be disposed in the non-display region NDA.

The display panel DP may include the pixels PX, initialization scan lines GIL1 to GILm, compensation scan lines GCL1 to GCLm, write scan lines GWL1 to GWLm, black scan lines GBL1 to GBLm, emission control lines ECL1 to ECLm, data lines DL1 to DLn, first and second control lines CSL1 and CSL2, a drive voltage line PL, a scan driver SDV, a data driver, an emission driver EDV, a driver IC DIC, and pads PD. Here, "m" and "n" are natural numbers of 2 or larger. The data driver may be a circuit configured in the driver IC DIC.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL1 to GBLm may extend in the first direction DR1 and may be electrically connected to the scan driver SDV. The data lines DL1 to DLn may extend in the second direction DR2 and may be electrically connected to the driver IC DIC. The emission control lines ECL1 to ECLm may extend in the first direction DR1 and may be electrically connected to the emission driver EDV.

The drive voltage line PL may include a portion extending in the first direction DR1 and a portion extending in the second portion DR2. The portion extending in the first direction DR1 and the portion extending in the second portion DR2 may be disposed on different layers. The drive voltage line PL may provide a drive voltage to the pixels PX.

The first control line CSL1 may be connected to the scan driver SDV. The second control line CSL2 may be connected to the emission driver EDV.

The driver IC DIC, the drive voltage line PL, the first control line CSL1, and the second control line CSL2 may be electrically connected to the pads PD. A flexible circuit film FCB may be electrically connected to the pads PD through an anisotropic conductive adhesive layer. The pads PD may be pads for connecting the flexible circuit film FCB to the display panel DP. The pads PD may be connected to the corresponding pixels PX through the drive voltage line PL, the first control line CSL1, and the second control line CSL2.

In some aspects, the pads PD may further include input pads. The input pads may be pads for connecting the flexible circuit film FCB to the input sensor INS (refer to FIG. 3). However, without being limited thereto, the input pads may be disposed in the input sensor INS and may be connected with the pads PD and a separate circuit board. Alternatively, the input sensor INS may be omitted, and the input pads may not be further included.

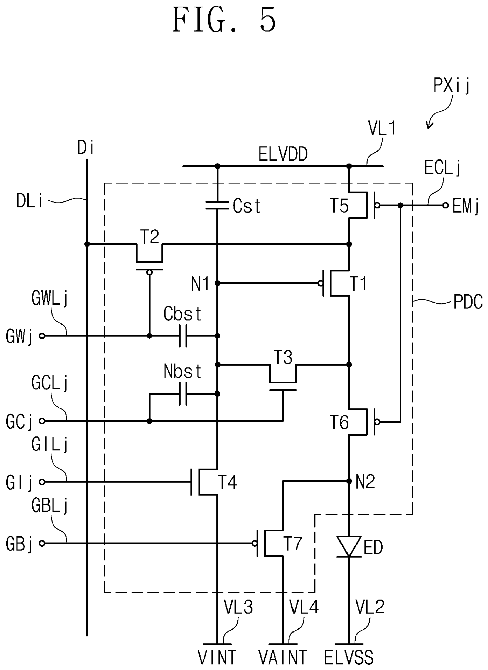

FIG. 5 is an equivalent circuit diagram of a pixel according to an embodiment of the present disclosure.

In FIG. 5, an equivalent circuit diagram of one pixel PXij among the plurality of pixels PX (refer to FIG. 4) is illustrated as an example. Since the plurality of pixels PX have the same circuit structure, description of the circuit structure for the pixel PXij may be applied to the remaining pixels PX, and detailed description of the remaining pixels PX will be omitted.

Referring to FIGS. 4 and 5, the pixel PXij is connected to the i-th data line DLi among the data lines DL1 to DLn, the j-th initialization scan line GILj among the initialization scan lines GIL1 to GILm, the j-th compensation scan line GCLj among the compensation scan lines GCL1 to GCLm, the j-th write scan line GWLj among the write scan lines GWL1 to GWLm, the j-th black scan line GBLj among the black scan lines GBL1 to GBLm, the j-th emission control line ECLj among the emission control lines ECL1 to ECLm, first and second drive voltage lines VL1 and VL2, and first and second initialization voltage lines VL3 and VL4. Here, "i" is an integer of 1 to n, and "j" is an integer of 1 to m.

The pixel PXij includes a light emitting element ED and a pixel circuit PDC. The light emitting element ED may be a light emitting diode. In an embodiment of the present disclosure, the light emitting element ED may be an organic light emitting diode including an organic light emitting layer, but is not particularly limited thereto. The pixel circuit PDC may control the amount of current flowing through the light emitting element ED in response to a data signal Di. The light emitting element ED may emit light having a certain luminance in response to the amount of current provided from the pixel circuit PDC.

The pixel circuit PDC may include first to seventh transistors T1, T2, T3, T4, T5, T6, and T7 and first to third capacitors Cst, Cbst, and Nbst. The configuration of the pixel circuit PDC according to the present disclosure is not limited to the embodiment illustrated in FIG. 5. The pixel circuit PDC illustrated in FIG. 5 is merely illustrative, and various changes and modifications may be made to the configuration of the pixel circuit PDC.

At least one of the first to seventh transistors T1, T2, T3, T4, T5, T6, and T7 may be a transistor having a low-temperature polycrystalline silicon (LTPS) semiconductor layer. At least one of the first to seventh transistors T1, T2, T3, T4, T5, T6, and T7 may be a transistor having an oxide semiconductor layer. For example, the third and fourth transistors T3 and T4 may be oxide semiconductor transistors, and the first, second, fifth, sixth, and seventh transistors T1, T2, T5, T6, and T7 may be LTPS transistors.

Specifically, the first transistor T1 directly affecting the brightness of the light emitting element ED may include a semiconductor layer formed of polycrystalline silicon having high reliability, and thus the display device having a high resolution may be implemented. In some embodiments, an oxide semiconductor has high carrier mobility and low leakage current, and thus a voltage drop is not great even though operating time is long. That is, the color of an image is not greatly changed based on a voltage drop even during a low-frequency operation, and thus the low-frequency operation is possible. Since the oxide semiconductor has an advantage of low leakage current as described herein, at least one of the third transistor T3, which is connected with a gate electrode of the first transistor T1, and the fourth transistor T4 may be employed as an oxide semiconductor to reduce power consumption while preventing leakage current that is likely to flow to the gate electrode.

Some of the first to seventh transistors T1, T2, T3, T4, T5, T6, and T7 may be P-type transistors, and the others may be N-type transistors. For example, the first, second, fifth, sixth, and seventh transistors T1, T2, T5, T6, and T7 may be P-type transistors, and the third and fourth transistors T3 and T4 may be N-type transistors.

The configuration of the pixel circuit PDC according to the present disclosure is not limited to the embodiment illustrated in FIG. 5. The pixel circuit PDC illustrated in FIG. 5 is merely illustrative, and various changes and modifications may be made to the configuration of the pixel circuit PDC. For example, the first to seventh transistors T1, T2, T3, T4, T5, T6, and T7 may all be P-type transistors or N-type transistors. Alternatively, the first, second, fifth, and sixth transistors T1, T2, T5, and T6 may be P-type transistors, and the third, fourth, and seventh transistors T3, T4, and T7 may be N-type transistors.

The j-th initialization scan line GILj, the j-th compensation scan line GCLj, the j-th write scan line GWLj, the j-th black scan line GBLj, and the j-th emission control line ECLj may transmit the j-th initialization scan signal GIj, the j-th compensation scan signal GCj, the j-th write scan signal GWj, the j-th black scan signal GBj, and the j-th emission control signal EMj to the pixel PXij, respectively. The i-th data line DLi transfers the i-th data signal Di to the pixel PXij. The i-th data signal Di may have a voltage level corresponding to an image signal that is input to the display device DD (refer to FIG. 1).

The first and second drive voltage lines VL1 and VL2 may transfer a first drive voltage ELVDD and a second drive voltage ELVSS to the pixel PXij, respectively. In some aspects, the first and second initialization voltage lines VL3 and VL4 may transfer a first initialization voltage VINT and a second initialization voltage VAINT to the pixel PXij, respectively.

The first transistor T1 is connected between the first drive voltage line VL1, which receives the first drive voltage ELVDD, and the light emitting element ED. The first transistor T1 includes a first electrode connected with the first drive voltage line VL1 via the fifth transistor T5, a second electrode connected with a pixel electrode (or, referred to as an anode) of the light emitting element ED via the sixth transistor T6, and a third electrode (e.g., a gate electrode) connected with one end of the first capacitor Cst (e.g., a first node N1). The first transistor T1 may receive the i-th data signal Di that the i-th data line DLi transfers based on a switching operation of the second transistor T2 and may supply a drive current to the light emitting element ED.

The second transistor T2 is connected between the i-th data line DLi and the first electrode of the first transistor T1. The second transistor T2 includes a first electrode connected with the i-th data line DLi, a second electrode connected with the first electrode of the first transistor T1, and a third electrode (e.g., a gate electrode) connected with the j-th write scan line GWLj. The second transistor T2 may be turned on based on the j-th write scan signal GWj transferred through the j-th write scan line GWLj and may transfer, to the first electrode of the first transistor T1, the i-th data signal Di transferred from the i-th data line DLi. One end of the second capacitor Cbst may be connected to the third electrode of the second transistor T2, and an opposite end of the second capacitor Cbst may be connected to the first node N1.

The third transistor T3 is connected between the second electrode of the first transistor T1 and the first node N1. The third transistor T3 includes a first electrode connected with the third electrode of the first transistor T1, a second electrode connected with the second electrode of the first transistor T1, and a third electrode (e.g., a gate electrode) connected with the j-th compensation scan line GCLj. The third transistor T3 may be turned on based on the j-th compensation scan signal GCj transferred through the j-th compensation scan line GCLj and may diode-connect the first transistor T1 by connecting the third electrode of the first transistor T1 and the second electrode of the first transistor T1. One end of the third capacitor Nbst may be connected to the third electrode of the third transistor T3, and an opposite end of the third capacitor Nbst may be connected to the first node N1.

The fourth transistor T4 is connected between the first initialization voltage line VL3 through which the first initialization voltage VINT is applied and the first node N1. The fourth transistor T4 includes a first electrode connected with the first initialization voltage line VL3 through which the first initialization voltage VINT is transferred, a second electrode connected with the first node N1, and a third electrode (e.g., a gate electrode) connected with the j-th initialization scan line GILj. The fourth transistor T4 is turned on based on the j-th initialization scan signal GIj transferred through the j-th initialization scan line GILj. The turned-on fourth transistor T4 initializes the potential of the third electrode of the first transistor T1 (that is, the potential of the first node N1) by transferring the first initialization voltage VINT to the first node N1.

The fifth transistor T5 includes a first electrode connected with the first drive voltage line VL1, a second electrode connected with the first electrode of the first transistor T1, and a third electrode (e.g., a gate electrode) connected to the j-th emission control line ECLj. The sixth transistor T6 includes a first electrode connected with the second electrode of the first transistor T1, a second electrode connected to the pixel electrode of the light emitting element ED, and a third electrode (e.g., a gate electrode) connected to the j-th emission control line ECLj.

The fifth and sixth transistors T5 and T6 are simultaneously turned on based on the j-th emission control signal EMj transferred through the j-th emission control line ECLj. The first drive voltage ELVDD applied through the turned-on fifth transistor T5 may be compensated for through the diode-connected first transistor T1 and thereafter may be transferred to the light emitting element ED through the sixth transistor T6.

The seventh transistor T7 includes a first electrode connected to the second initialization voltage line VL4 through which the second initialization voltage VAINT is transferred, a second electrode connected with the second electrode of the sixth transistor T6, and a third electrode (e.g., a gate electrode) connected with the j-th black scan line GBLj. The second initialization voltage VAINT may have a voltage level lower than or equal to the voltage level of the first initialization voltage VINT.

The one end of the first capacitor Cst is connected with the third electrode of the first transistor T1, and an opposite end of the first capacitor Cst is connected with the first drive voltage line VL1. A cathode of the light emitting element ED may be connected with the second drive voltage line VL2 that transfers the second drive voltage ELVSS. The second drive voltage ELVSS may have a lower voltage level than the first drive voltage ELVDD.

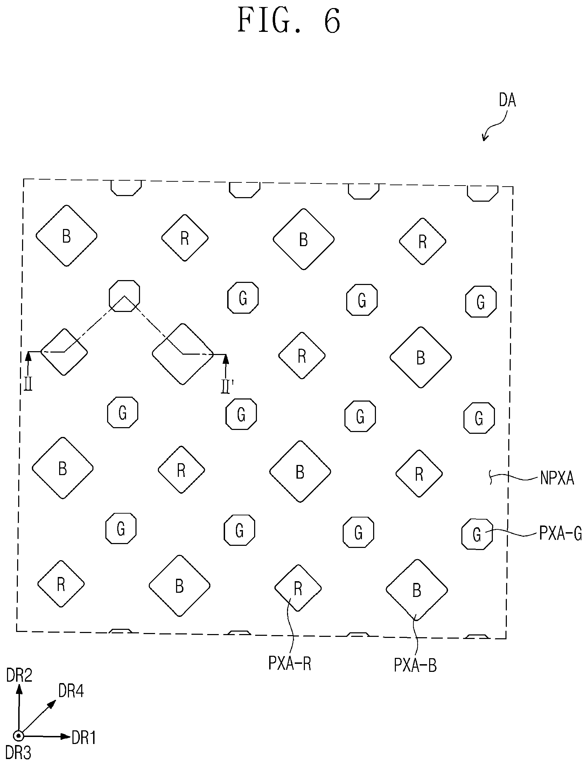

FIG. 6 is an enlarged plan view of a portion of the display region of the display panel according to an embodiment of the present disclosure. FIG. 6 is a plan view of the display module DM as viewed from above the display surface IS (refer to FIG. 2) of the display module DM (refer to FIG. 2) and illustrates an arrangement of emissive regions PXA-R, PXA-G, and PXA-B.

Referring to FIG. 6, the display region DA may include the first to third emissive regions PXA-R, PXA-G, and PXA-B and a peripheral region NPXA surrounding the first to third emissive regions PXA-R, PXA-G, and PXA-B. The first to third emissive regions PXA-R, PXA-G, and PXA-B may correspond to regions through which light provided from light emitting elements is emitted. The first to third emissive regions PXA-R, PXA-G, and PXA-B may be distinguished from one another based on the colors of light emitted toward the outside of the display module DM (refer to FIG. 2).

The first to third emissive regions PXA-R, PXA-G, and PXA-B may provide first light of a first color, second light of a second color, and third light of a third color. For example, the first light of the first color may be red light, the second light of the second color may be green light, and the third light of the third color may be blue light. However, examples of the first light of the first color, the second light of the second color, and the third light of the third color are not necessarily limited thereto.

The first to third emissive regions PXA-R, PXA-G, and PXA-B may be defined as regions where upper surfaces of anodes are exposed by light emitting openings that will be described herein. The peripheral region NPXA may set the boundaries between the first to third emissive regions PXA-R, PXA-G, and PXA-B and may prevent color mixing between the first to third emissive regions PXA-R, PXA-G, and PXA-B.

A plurality of first emissive regions PXA-R, a plurality of second emissive regions PXA-G, and a plurality of third emissive regions PXA-B may be provided. The plurality of first emissive regions PXA-R, the plurality of second emissive regions PXA-G, and the plurality of third emissive regions PXA-B may have a predetermined arrangement in the display region DA and may be repeatedly disposed. For example, the first and third emissive regions PXA-R and PXA-B may be alternately arranged in the first direction DR1 to form a "first group". The second emissive regions PXA-G may be arranged in the first direction DR1 to form a "second group". The "first group" and the "second group" may be provided in plural numbers, and the "first groups" and the "second groups" may be alternately arranged in the second direction DR2.

One second emissive region PXA-G may be spaced apart from one first emissive region PXA-R or one third emissive region PXA-B in a fourth direction DR4. The fourth direction DR4 may be defined as a direction between the first and second directions DR1 and DR2.

In some embodiments, FIG. 6 illustrates an arrangement of the first to third emissive regions PXA-R, PXA-G, and PXA-B, and without being limited thereto, the first to third emissive regions PXA-R, PXA-G, and PXA-B may be arranged in various forms. In an embodiment, as illustrated in FIG. 6, the first to third emissive regions PXA-R, PXA-G, and PXA-B may have a PENTILE^{™} arrangement form. Alternatively, the first to third emissive regions PXA-R, PXA-G, and PXA-B may have a stripe arrangement form or a Diamond Pixel^{™} arrangement form.

The first to third emissive regions PXA-R, PXA-G, and PXA-B may have various shapes when viewed from above the plane. For example, the first to third emissive regions PXA-R, PXA-G, and PXA-B may have a polygonal, circular, or oval shape. FIG. 6 illustrates the first and third emissive regions PXA-R and PXA-B having a quadrangular shape (or, a rhombic shape) when viewed from above the plane and the second emissive regions PXA-G having an octagonal shape when viewed from above the plane.

When viewed from above the plane, the first to third emissive regions PXA-R, PXA-G, and PXA-B may have the same shape, or at least some of the first to third emissive regions PXA-R, PXA-G, and PXA-B may have different shapes. FIG. 6 illustrates the first and third emissive regions PXA-R and PXA-B having the same shape when viewed from above the plane and the second emissive region PXA-G having a shape different from those of the first and third emissive regions PXA-R and PXA-B when viewed from above the plane.

At least some of the first to third emissive regions PXA-R, PXA-G, and PXA-B may have different areas when viewed from above the plane. In an embodiment, the area of the first emissive region PXA-R emitting red light may be greater than the area of the second emissive region PXA-G emitting green light and may be smaller than the area of the third emissive region PXA-B emitting blue light. However, the relative size relationship between the first to third emissive regions PXA-R, PXA-G, and PXA-B based on the colors of emitted light is not limited thereto and may vary based on the design of the display module DM (refer to FIG. 2). Furthermore, without being limited thereto, the first to third emissive regions PXA-R, PXA-G, and PXA-B may have the same area when viewed from above the plane.

In some embodiments, the shapes, areas, and arrangement of the first to third emissive regions PXA-R, PXA-G, and PXA-B of the display module DM (refer to FIG. 2) of the present disclosure may be designed in various ways based on the colors of emitted light or the size and configuration of the display module DM (refer to FIG.2) and are not limited to the embodiment illustrated in FIG. 6.

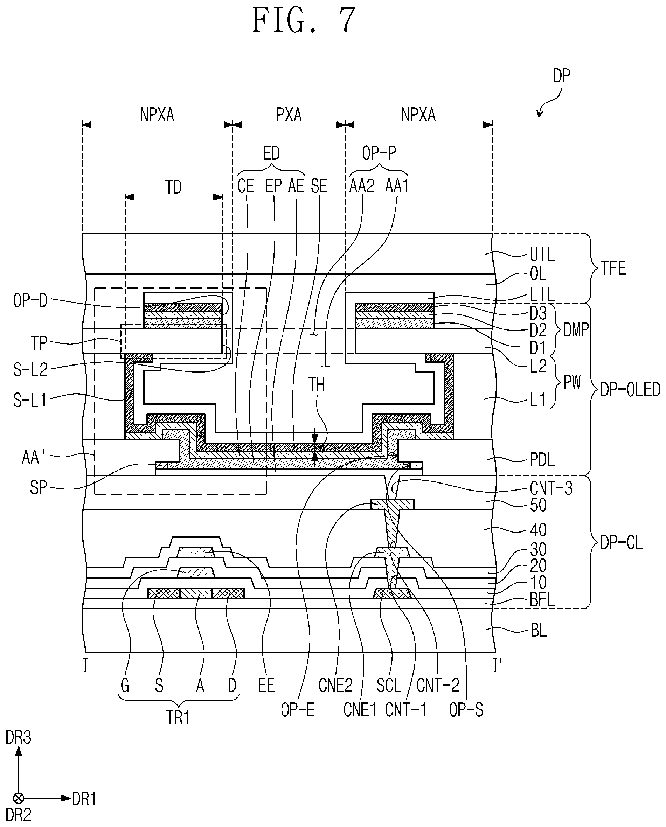

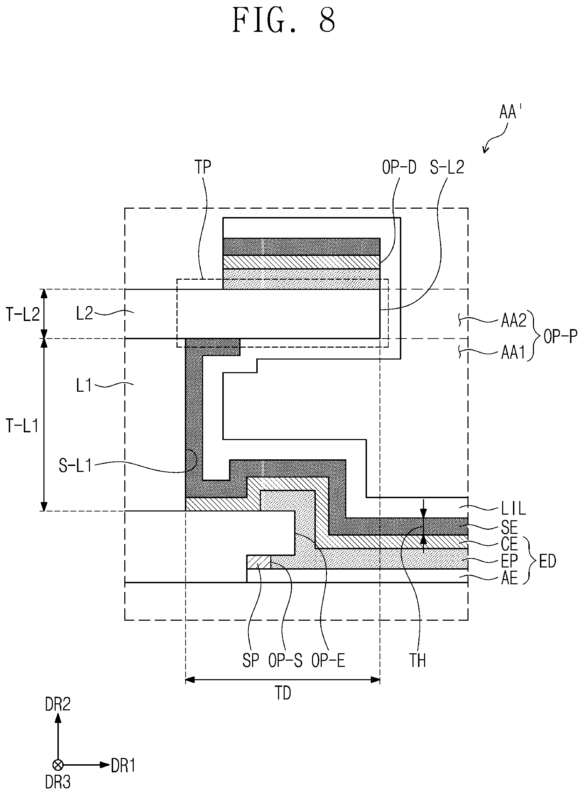

FIG. 7 is a sectional view of the display panel taken along line I-I' of FIG. 4 according to an embodiment of the present disclosure. FIG. 8 is an enlarged view illustrating region AA' of FIG. 7 according to an embodiment of the present disclosure. In describing FIGS. 7 and 8, the description will be made with reference to FIG. 3, and descriptions of the same reference numerals will be omitted.

FIG. 7 is a sectional view of one emissive region PXA in the display region DA (refer to FIG. 6), and the emissive region PXA of FIG. 7 may correspond to one of the first to third emissive regions PXA-R, PXA-G, and PXA-B of FIG. 6. Referring to FIG. 7, the display panel DP may include the base layer BL, the circuit element layer DP-CL, the display element layer DP-OLED, and the thin film encapsulation layer TFE.

The display panel DP may include a plurality of insulating layers, a semiconductor pattern, a conductive pattern, and a signal line. An insulating layer, a semiconductor layer, and a conductive layer are formed by coating, deposition, or the like. Thereafter, the insulating layer, the semiconductor layer, and the conductive layer may be selectively subjected to patterning by photolithography and etching. The semiconductor pattern, the conductive pattern, and the signal line included in the circuit element layer DP-CL and the display element layer DP-OLED may be formed by at least the above-described method and the methods described herein.

The circuit element layer DP-CL may be disposed on the base layer BL. The circuit element layer DP-CL may include a buffer layer BFL, a transistor TR1, a signal transmission region SCL, first to fifth insulating layers 10, 20, 30, 40, and 50, an electrode EE, and a plurality of connecting electrodes CNE1 and CNE2.

The buffer layer BFL may be disposed on the base layer BL. The buffer layer BFL may improve a coupling force between the base layer BL and a semiconductor pattern. The buffer layer BFL may include silicon oxide layers and silicon nitride layers. The silicon oxide layers and the silicon nitride layers may be alternately stacked one above another.

The semiconductor pattern may be disposed on the buffer layer BFL. The semiconductor pattern may include poly-silicon. However, without being limited thereto, the semiconductor pattern may include amorphous silicon or metal oxide. In FIG. 7, a portion of the semiconductor pattern is illustrated as an example, and in some aspects, the semiconductor pattern may be disposed in the plurality of emissive regions PXA-R, PXA-G, PXA-B (refer to FIG. 6). The semiconductor pattern may be arranged across the plurality of emissive regions PXA-R, PXA-G, PXA-B according to a specific rule. The semiconductor pattern may have different electrical properties based on whether the semiconductor pattern is doped or not. The semiconductor pattern may include a first region having a high doping concentration and a second region having a low doping concentration. The first region may be doped with an N-type dopant or a P-type dopant. A P-type transistor may include a first region doped with a P-type dopant.

The first region has a higher conductivity than the second region and substantially serves as an electrode or a signal line. The second region may substantially correspond to an active (or, channel) region of the transistor. In other words, one portion of the semiconductor pattern may be the active region of the transistor, another portion may be a source or drain of the transistor, and another portion may be a conductive region.

The source S, the active region A, and the drain D of the transistor TR1 may be formed from the semiconductor pattern. A portion of the signal transmission region SCL formed from the semiconductor pattern is illustrated in FIG. 7. Although not separately illustrated, the signal transmission region SCL may be connected to the drain D of the transistor TR1 when viewed from above the plane.

The first to fifth insulating layers 10, 20, 30, 40, and 50 may be disposed on the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source S, the active region A, and the drain D of the transistor TR1 and the signal transmission region SCL that are disposed on the buffer layer BFL. A gate G of the transistor TR1 may be disposed on the first insulating layer 10. The second insulating layer 20 may be disposed on the first insulating layer 10 and may cover the gate G. The electrode EE may be disposed on the second insulating layer 20. The third insulating layer 30 may be disposed on the second insulating layer 20 and may cover the electrode EE.

The first connecting electrode CNE1 may be disposed on the third insulating layer 30. The first connecting electrode CNE1 may be connected to the signal transmission region SCL through a contact hole CNT-1 penetrating the first to third insulating layers 10, 20, and 30. The fourth insulating layer 40 may be disposed on the third insulating layer 30 and may cover the first connecting electrode CNE1. The fourth insulating layer 40 may be an organic layer.

The second connecting electrode CNE2 may be disposed on the fourth insulating layer 40. The second connecting electrode CNE2 may be connected to the first connecting electrode CNE1 through a contact hole CNT-2 penetrating the fourth insulating layer 40. The fifth insulating layer 50 may be disposed on the fourth insulating layer 40 and may cover the second connecting electrode CNE2. The fifth insulating layer 50 may be an organic layer.

The display element layer DP-OLED may be disposed on the circuit element layer DP-CL. The display element layer DP-OLED may include a light emitting element ED, a sacrificial pattern SP, a pixel defining layer PDL, a barrier wall PW, an auxiliary electrode SE, and dummy patterns DMP.

The light emitting element ED may include an anode AE (or, a first electrode), an emission pattern EP (or, an intermediate layer), and a cathode CE (or, a second electrode).

The anode AE may be disposed on the fifth insulating layer 50 of the circuit element layer DP-CL. The anode AE may be a transmissive electrode, a transflective electrode, or a reflective electrode. The anode AE may be connected to the second connecting electrode CNE2 by a connection contact hole CNT-3 defined to penetrate the fifth insulating layer 50. Accordingly, for example, the anode AE may be electrically connected to the signal transmission region SCL through the first and second connecting electrodes CNE1 and CNE2 and may be electrically connected to a corresponding circuit element. The anode AE may include a single-layer structure or a multi-layer structure. The anode AE may include a plurality of layers including ITO and Ag. For example, the anode AE may include a layer including ITO (hereinafter, referred to as the lower ITO layer), a layer disposed on the lower ITO layer and including Ag (hereinafter, referred to as the Ag layer), and a layer disposed on the Ag layer and including ITO (hereinafter, referred to as the upper ITO layer).

The sacrificial pattern SP may be disposed between the anode AE and the pixel defining layer PDL. A sacrificial opening OP-S that exposes a portion of the upper surface of the anode AE may be defined in the sacrificial pattern SP. The sacrificial opening OP-S may overlap a light emitting opening OP-E that will be described herein.

The pixel defining layer PDL may be disposed over the base layer BL. In more detail, the pixel defining layer PDL may be disposed on the fifth insulating layer 50 of the circuit element layer DP-CL. The pixel defining layer PDL may have the light emitting opening OP-E defined therein. The light emitting opening OP-E may correspond to the anode AE, and the pixel defining layer PDL may expose at least a portion of the anode AE through the light emitting opening OP-E.

The light emitting opening OP-E may correspond to the sacrificial opening OP-S of the sacrificial pattern SP. According to this example embodiment, the upper surface of the anode AE may be spaced apart from the pixel defining layer PDL at the section where the sacrificial pattern SP is between the upper surface of the anode AE and the pixel defining layer PDL. Accordingly, for example, damage to the anode AE in a process of forming the light emitting opening OP-E may be prevented.

The area of the light emitting opening OP-E may be smaller than the area of the sacrificial opening OP-S when viewed from above the plane. That is, the inner surface of the pixel defining layer PDL that defines the light emitting opening OP-E may be closer to the center of the anode AE than the inner surface of the sacrificial pattern SP that defines the sacrificial opening OP-S. However, without being limited thereto, the inner surface of the sacrificial pattern SP that defines the sacrificial opening OP-S may be substantially aligned with the inner surface of the pixel defining layer PDL that defines the light emitting opening OP-E.

The pixel defining layer PDL may include an inorganic insulating material. For example, the pixel defining layer PDL may include silicon nitride SiNₓ. The pixel defining layer PDL may be disposed between the anode AE and the barrier wall PW and may block electrical connection between the anode AE and the barrier wall PW.

The barrier wall PW may be disposed on the pixel defining layer PDL. The barrier wall PW may have a barrier wall opening OP-P defined therein. The barrier wall opening OP-P may overlap the light emitting opening OP-E and may expose at least a portion of the anode AE.

The barrier wall PW may have an undercut shape on the section. The barrier wall PW may include multiple layers sequentially stacked one above another, and at least one layer among the multiple layers may be recessed relative to the other layers. Accordingly, for example, the barrier wall PW may include a tip portion TP.

The barrier wall PW may include a first barrier wall layer L1 and a second barrier wall layer L2. The first barrier wall layer L1 may be disposed on the pixel defining layer PDL, and the second barrier wall layer L2 may be disposed on the first barrier wall layer L1. As illustrated in FIG. 7, the thickness of the first barrier wall layer L1 may be greater than the thickness of the second barrier wall layer L2. However, embodiments of the present disclosure are not limited thereto.

In comparison to the second barrier wall layer L2, the first barrier wall layer L1 may be relatively recessed with respect to the emissive region PXA. The first barrier wall layer L1 may be undercut with respect to the second barrier wall layer L2. The portion of the second barrier wall layer L2 that protrudes from the first barrier wall layer L1 toward the emissive region PXA may be defined as the tip portion TP within the barrier wall PW. That is, the second barrier wall layer L2 may include the tip portion TP protruding from the first barrier wall layer L1 toward the barrier wall opening OP-P.

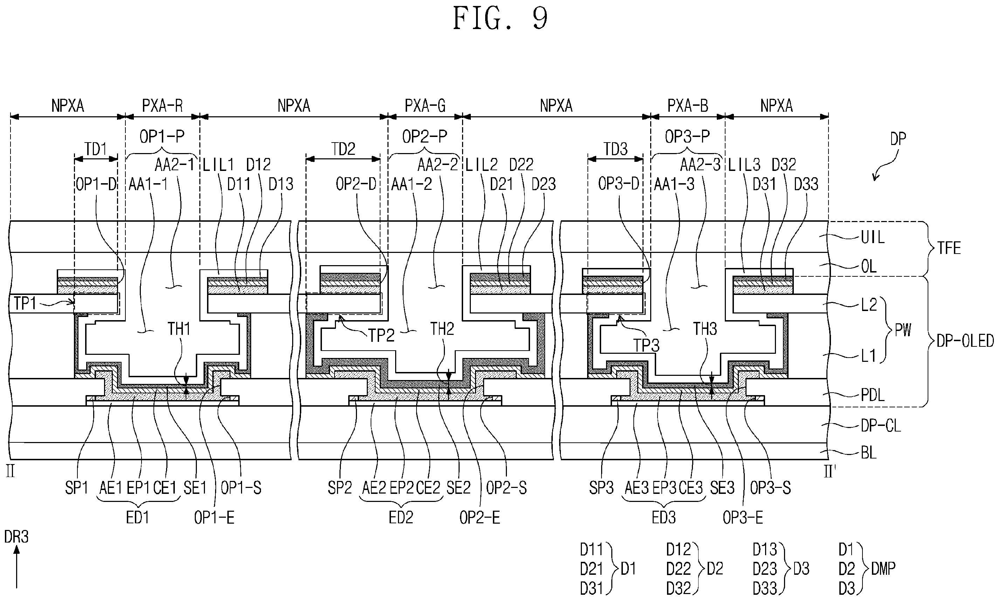

Referring to FIGS. 7 and 8, the length TD of the tip portion TP in the first direction DR1 may correspond to the length from a first inner surface S-L1 of the first barrier wall layer L1 that overlaps the pixel defining layer PDL to a second inner surface S-L2 of the second barrier wall layer L2. The length TD of the tip portion TP in the first direction DR1 may vary based on regions. Descriptions thereof are provided herein with reference to FIG. 9. The second barrier wall layer L2 may have a thickness T-L2 of 2500 Å to 3000 Å. Since the thickness T-L2 of the second barrier wall layer L2 is relatively large, the shape of the tip portion TP may be maintained even for cases in which the length TD of the tip portion TP in the first direction DR1 is varied.

Referring again to FIG. 7, the barrier wall opening OP-P defined in the barrier wall PW may include a first region AA1 and a second region AA2. The first barrier wall layer L1 may include the first inner surface S-L1 that defines the first region AA1 of the barrier wall opening OP-P, and the second barrier wall layer L2 may include the second inner surface S-L2 that defines the second region AA2 of the barrier wall opening OP-P. On the section, the second inner surface S-L2 of the second barrier wall layer L2 may be closer to the center of the anode AE than the first inner surface S-L1 of the first barrier wall layer L1. The first inner surface S-L1 may be recessed in a direction away from the center of the anode AE with respect to the second inner surface S-L2.

The width of the first region AA1 may be different from the width of the second region AA2. The width of the first region AA1 may be greater than the width of the second region AA2. In this case, the second region AA2 of the barrier wall opening OP-P may be a region that defines the tip portion TP.

Each of the first barrier wall layer L1 and the second barrier wall layer L2 may include a conductive material. For example, the conductive material may include metal, transparent conductive oxide (TCO), or a combination thereof. For example, the metal may include gold (Au), silver (Ag), aluminium (Al), magnesium (Mg), lithium (Li), molybdenum (Mo), titanium (Ti), copper (Cu), or an alloy. The transparent conductive oxide may include indium tin oxide (ITO), indium zinc oxide (IZO), zinc oxide, indium oxide, indium gallium oxide, indium gallium zinc oxide (IGZO), or aluminium zinc oxide.

Although FIG. 7 illustrates an example that the first inner surface S-L1 and the second inner surface S-L2 are perpendicular to the upper surface of the pixel defining layer PDL, embodiments of the present disclosure are not limited thereto. For example, the barrier wall PW may have a tapered shape or an inverted tapered shape.

The emission pattern EP may be disposed on the anode AE. The emission pattern EP may include an emissive layer including a luminescent material. The emission pattern EP may further include a hole injection layer (HIL) and a hole transport layer (HTL) that are disposed between the anode AE and the emissive layer and may further include an electron transport layer (ETL) and an electron injection layer (EIL) that are disposed on the emissive layer. The emission pattern EP may be referred to as an "organic layer" or an "intermediate layer".

The emission pattern EP may be subjected to patterning by the tip portions TP defined in the barrier wall PW. The emission pattern EP may be disposed in the sacrificial opening OP-S, the light emitting opening OP-E, and the barrier wall opening OP-P. The emission pattern EP may be deposited on a portion of the upper surface of the pixel defining layer PDL exposed from the barrier wall opening OP-P. That is, opposite ends of the emission pattern EP may be formed on the upper surface of the pixel defining layer PDL. The emission pattern EP may be spaced apart from the side surface of the barrier wall PW when viewed from above the plane. For example, the emission pattern EP may be spaced apart from the first inner surface S-L1 of the first barrier wall layer L1 when viewed from above the plane. That is, the emission pattern EP may not make contact with the barrier wall PW.

A p-doped hole injection layer of the hole injection layer included in the emission pattern EP may have conductivity. In this case, if the emission pattern EP is formed such that the emission pattern EP is in contact with the barrier wall PW, the barrier wall PW including the conductive material and the emission pattern EP may be electrically connected with each other, and therefore a leakage current may occur. According to the present disclosure, as the emission pattern EP is spaced apart from the barrier wall PW when viewed from above the plane, a leakage current may be prevented from occurring even though a portion of the emission pattern EP (e.g., the p-doped hole injection layer) has conductivity.

The cathode CE may be disposed on the emission pattern EP. The cathode CE may be subjected to patterning by the tip portion defined in the barrier wall PW. At least a portion of the cathode CE may be disposed in the barrier wall opening OP-P. The cathode CE may be deposited on the upper surface of the pixel defining layer PDL exposed from the barrier wall opening OP-P. That is, opposite ends of the cathode CE may be formed on the pixel defining layer PDL.

The opposite ends of the cathode CE may make contact with the side surface of the barrier wall PW and may be electrically connected with the side surface of the barrier wall PW. Although FIG. 7 illustrates an example that the cathode CE makes contact with the side surface of the barrier wall PW, embodiments of the present disclosure are not limited thereto. For example, the opposite ends of the cathode CE may be spaced apart from the side surface of the barrier wall PW when viewed from above the plane. That is, the cathode CE may be spaced apart from the first inner surface S-L1 of the first barrier wall layer L1 when viewed from above the plane. In this case, the cathode CE may be electrically connected with the barrier wall PW through the auxiliary electrode SE.

The cathode CE may have conductivity. As long as the cathode CE is capable of having conductivity, the cathode CE may be formed of various materials such as, for example, metal, transparent conductive oxide (TCO), or a conductive polymer material. For example, the cathode CE may include silver (Ag), magnesium (Mg), lead (Pb), copper (Cu), or a compound thereof.

The auxiliary electrode SE may be disposed on the light emitting element ED. For example, the auxiliary electrode SE may be disposed on the cathode CE. A portion of the auxiliary electrode SE may be disposed in the barrier wall opening OP-P. The auxiliary electrode SE may extend along the first inner surface S-L1 of the first barrier wall layer L1. For example, the auxiliary electrode SE may extend in contact with the first inner surface S-L1 of the first barrier wall layer L1. The auxiliary electrode SE may cover the opposite ends of the cathode CE.

The auxiliary electrode SE may make contact with the first inner surface S-L1 of the first barrier wall layer L1 and may make contact with the cathode CE. That is, the auxiliary electrode SE may be electrically connected with the barrier wall PW and the cathode CE. The barrier wall PW may receive the second drive voltage ELVSS (refer to FIG. 5), and the auxiliary electrode SE may be electrically connected to the barrier wall PW and may receive the second drive voltage ELVSS. Accordingly, for example, the cathode CE electrically connected with the auxiliary electrode SE may receive the second drive voltage ELVSS.

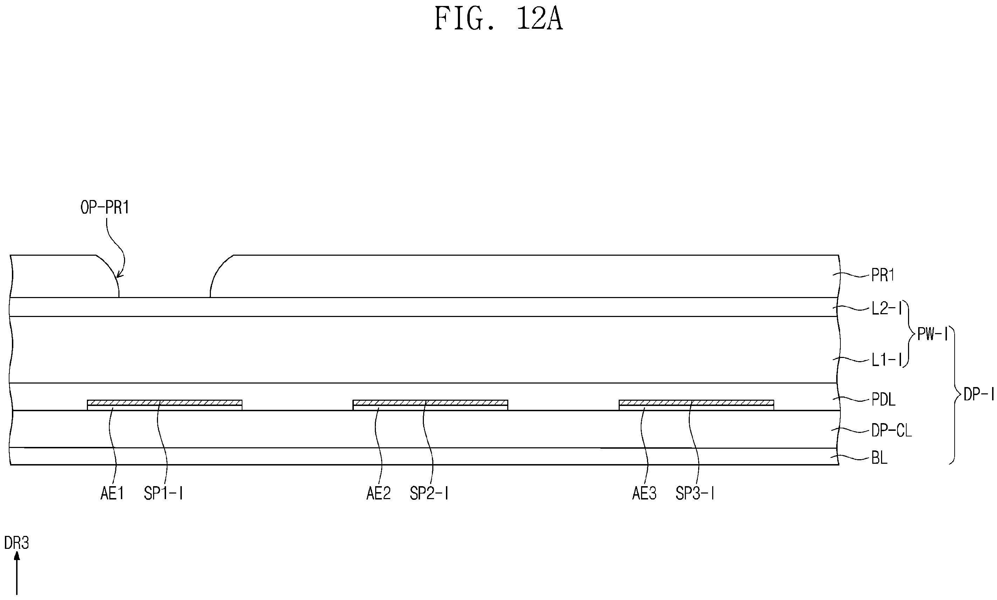

The auxiliary electrode SE may make contact with a portion of the lower surface of the tip portion TP. The auxiliary electrode SE may not make contact with at least a portion of the lower surface of the tip portion TP. Accordingly, for example, embodiments of the present disclosure include preventing the auxiliary electrode SE from being formed on the entire lower surface of the tip portion TP, and embodiments of the present disclosure include preventing an etchant for forming the dummy patterns DMP in a patterning process from flowing to the auxiliary electrode SE and the cathode CE through distal ends of the dummy patterns DMP. Descriptions thereof are provided herein with reference to FIGS. 12A to 12H.

The auxiliary electrode SE may have conductivity. According to the present disclosure, the cathode CE may be electrically connected with the barrier wall PW through the auxiliary electrode SE. The adhesive force between the auxiliary electrode SE and the cathode CE and the adhesive force between the auxiliary electrode SE and the barrier wall PW may be higher than the adhesive force between the cathode CE and the barrier wall PW. Accordingly, for example, the auxiliary electrode SE may eliminate a phenomenon in which the cathode CE making contact with the barrier wall PW is lifted, and thus a phenomenon in which foreign matter infiltrates into the display element layer DP-OLED may be eliminated.

In an embodiment of the present disclosure, the auxiliary electrode SE may include transparent conductive oxide (TCO). For example, the auxiliary electrode SE may include at least one of indium tin oxide (ITO), indium gallium zinc oxide (IGZO), and indium zinc oxide (IZO). The auxiliary electrode SE may preferably include indium zinc oxide (IZO). The auxiliary electrode SE may be composed of indium oxide InOₓ having a weight ratio of about 90% and zinc oxide ZnOₓ having a weight ratio of about 10%. However, without being limited thereto, the auxiliary electrode SE may be formed of various materials, such as, for example, a conductive polymer material, as long as the auxiliary electrode SE is capable of having conductivity.

The thickness TH of the auxiliary electrode SE may be a thickness by which light transmittance is maximized (e.g., compared to other candidate thicknesses TH of the auxiliary electrode SE). The thickness TH of the auxiliary electrode SE by which light transmittance is maximized may vary based on the wavelength of light. Accordingly, for example, the thickness TH of the auxiliary electrode SE may vary based on the wavelength of light of the emissive region such that light transmittance is maximized. Aspects of the present disclosure support, based on the wavelength of light to be transmitted by a given auxiliary electrode SE, varying the thickness TH of the auxiliary electrode SE in association with maximizing transmittance of the light. Descriptions thereof are provided herein with reference to FIG. 9.

The dummy patterns DMP may be disposed on the barrier wall PW. The dummy patterns DMP may include a first dummy pattern D1, a second dummy pattern D2, and a third dummy pattern D3. The first to third dummy patterns D1, D2, and D3 may be sequentially stacked on the upper surface of the second barrier wall layer L2 of the barrier wall PW in the third direction DR3.

The first dummy pattern D1 may include an organic material. For example, the first dummy pattern D1 may include the same material as the emission pattern EP. The first dummy pattern D1 may be simultaneously formed with the emission pattern EP through one process and may be separated from the emission pattern EP by the undercut shape of the barrier wall PW.

The second dummy pattern D2 may include a conductive material. For example, the second dummy pattern D2 may include the same material as the cathode CE. The second dummy pattern D2 may be simultaneously formed with the cathode CE through one process and may be separated from the cathode CE by the undercut shape of the barrier wall PW.

The third dummy pattern D3 may include a conductive material. For example, the third dummy pattern D3 may include the same material as the auxiliary electrode SE. The third dummy pattern D3 may be simultaneously formed with the auxiliary electrode SE through one process and may be separated from the auxiliary electrode SE by the undercut shape of the barrier wall PW.

A dummy opening OP-D may be defined in the dummy patterns DMP. The dummy opening OP-D may overlap the light emitting opening OP-E. Each of the first to third dummy patterns D1, D2, and D3, when viewed from above the plane, may have a closed-line shape surrounding the emissive region PXA.

Although FIG. 7 illustrates an example that the inner surfaces of the first to third dummy patterns D1, D2, and D3 are aligned with the second inner surface S-L2 of the second barrier wall layer L2, embodiments of the present disclosure are not limited thereto, and the first to third dummy patterns D1, D2, and D3 may cover the second inner surface S-L2 of the second barrier wall layer L2.

The thin film encapsulation layer TFE may be disposed on the display element layer DP-OLED. The thin film encapsulation layer TFE may include a lower inorganic encapsulation pattern LIL, an organic encapsulation film OL, and an upper inorganic encapsulation film UIL.

The lower inorganic encapsulation pattern LIL may be disposed on the auxiliary electrode SE. The lower inorganic encapsulation pattern LIL may be formed to correspond to the light emitting opening OP-E. The lower inorganic encapsulation pattern LIL may make direct contact with the auxiliary electrode SE. The lower inorganic encapsulation pattern LIL may make contact with the lower surface of the tip portion TP. A portion of the lower inorganic encapsulation pattern LIL may cover the auxiliary electrode SE within the barrier wall opening OP-P.

The organic encapsulation film OL may cover the lower inorganic encapsulation pattern LIL and may provide a flat upper surface. The upper inorganic encapsulation film UIL may be disposed on the organic encapsulation film OL.

The lower inorganic encapsulation pattern LIL and the upper inorganic encapsulation film UIL may protect the display element layer DP-OLED from moisture/oxygen, and the organic encapsulation film OL may protect the display element layer DP-OLED from foreign matter such as, for example, dust particles.

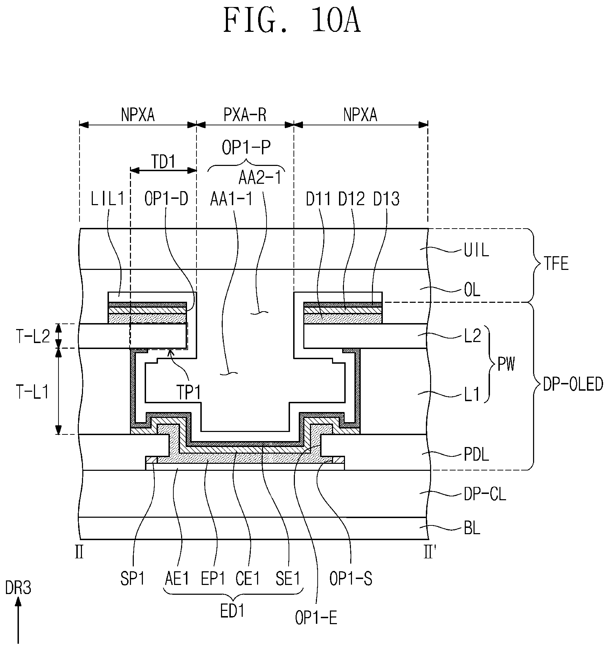

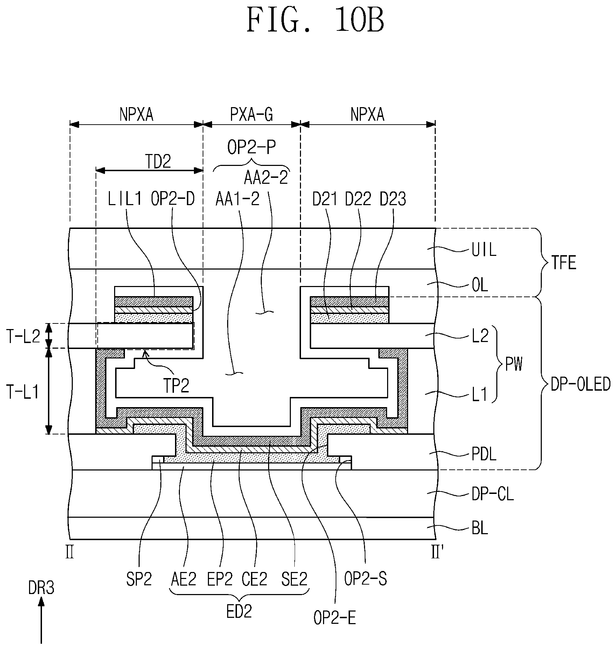

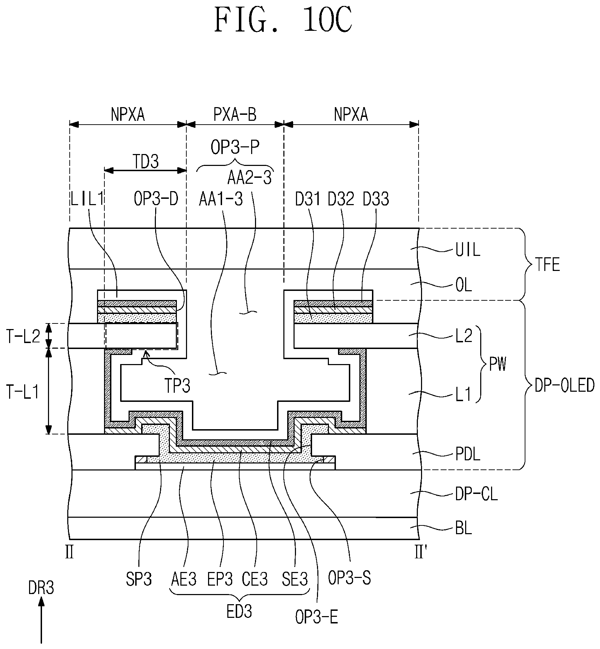

FIG. 9 is a sectional view taken along line II-II' of FIG. 6 according to an embodiment of the present disclosure. FIG. 10A is an enlarged sectional view illustrating the first emissive region of FIG. 9 according to an embodiment of the present disclosure. FIG. 10B is an enlarged sectional view illustrating the second emissive region of FIG. 9 according to an embodiment of the present disclosure. FIG. 10C is an enlarged sectional view illustrating the third emissive region of FIG. 9 according to an embodiment of the present disclosure.

FIG. 9 is an enlarged view illustrating one first emissive region PXA-R, one second emissive region PXA-G, and one third emissive region PXA-B, and the description of the emissive region PXA of FIG. 7 may be identically applied to each of the first to third emissive regions PXA-R, PXA-G, and PXA-B.

Referring to FIGS. 9 to 10C, the display panel DP according to this example embodiment may include the base layer BL, the circuit element layer DP-CL, the display element layer DP-OLED, and the thin film encapsulation layer TFE. The display element layer DP-OLED may include light emitting elements ED1, ED2, and ED3, sacrificial patterns SP1, SP2, and SP3, the pixel defining layer PDL, the barrier wall PW, auxiliary electrodes SE1, SE2, and SE3, and dummy patterns DMP.

The light emitting elements ED1, ED2, and ED3 may include the first light emitting element ED1, the second light emitting element ED2, and the third light emitting element ED3. The first light emitting element ED1 may overlap a first light emitting opening OP1-E. The second light emitting element ED2 may overlap a second light emitting opening OP2-E. The third light emitting element ED3 may overlap a third light emitting opening OP3-E.

The first light emitting element ED1 may include a first anode AE1, a first emission pattern EP1, and a first cathode CE1. The second light emitting element ED2 may include a second anode AE2, a second emission pattern EP2, and a second cathode CE2. The third light emitting element ED3 may include a third anode AE3, a third emission pattern EP3, and a third cathode CE3. The first to third anodes AE1, AE2, and AE3 may be provided in a plurality of patterns. In an embodiment, the first emission pattern EP1 may provide red light, the second emission pattern EP2 may provide green light, and the third emission pattern EP3 may provide blue light.

The first to third light emitting openings OP1-E, OP2-E, and OP3-E may be defined in the pixel defining layer PDL. The first light emitting opening OP1-E may expose at least a portion of the first anode AE1. The second light emitting opening OP2-E may expose at least a portion of the second anode AE2. The third light emitting opening OP3-E may expose at least a portion of the third anode AE3.

The sacrificial patterns SP1, SP2, and SP3 may include the first sacrificial pattern SP1, the second sacrificial pattern SP2, and the third sacrificial pattern SP3. The first to third sacrificial patterns SP1, SP2, and SP3 may be disposed on the upper surfaces of the first to third anodes AE1, AE2, and AE3, respectively. First to third sacrificial openings OP1-S, OP2-S, and OP3-S overlapping the first to third light emitting openings OP1-E, OP2-E, and OP3-E may be defined in the first to third sacrificial patterns SP1, SP2, and SP3, respectively.

In this example embodiment, first to third barrier wall openings OP1-P, OP2-P, and OP3-P overlapping the first to third light emitting openings OP1-E, OP2-E, and OP3-E, respectively, may be defined in the barrier wall PW. The first emissive region PXA-R may be defined as a region of the upper surface of the first anode AE1 exposed by the first barrier wall opening OP1-P. The second emissive region PXA-G may be defined as a region of the upper surface of the second anode AE2 exposed by the second barrier wall opening OP2-P. The third emissive region PXA-B may be defined as a region of the upper surface of the third anode AE3 exposed by the third barrier wall opening OP3-P.

The first to third barrier wall openings OP1-P, OP2-P, and OP3-P may include first regions AA1-1, AA1-2, and AA1-3 corresponding to the first region AA1 (refer to FIG. 7) described herein with reference to FIG. 7 and second regions AA2-1, AA2-2, and AA2-3 corresponding to the second region AA2 (refer to FIG. 7) described herein with reference to FIG. 7. The first barrier wall layer L1 may include first inner surfaces S-L1 (refer to FIG. 7) that define the first regions AA1-1, AA1-2, and AA1-3 of the first to third barrier wall openings OP1-P, OP2-P, and OP3-P, and the second barrier wall layer L2 may include second inner surfaces S-L2 (refer to FIG. 7) that define the second regions AA2-1, AA2-2, and AA2-3 of the first to third barrier wall openings OP1-P, OP2-P, and OP3-P.

The first emission pattern EP1 and the first cathode CE1 may be disposed in the first barrier wall opening OP1-P, the second emission pattern EP2 and the second cathode CE2 may be disposed in the second barrier wall opening OP2-P, and the third emission pattern EP3 and the third cathode CE3 may be disposed in the third barrier wall opening OP3-P.

In this example embodiment, the first to third emission patterns EP1, EP2, and EP3 and the first to third cathodes CE1, CE2, and CE3 may be physically separated by the second barrier wall layer L2 that forms tip portions TP1, TP2, and TP3 and may be formed in the light emitting openings OP1-E, OP2-E, and OP3-E and the barrier wall openings OP1-P, OP2-P, and OP3-P. The first to third emission patterns EP1, EP2, and EP3 may be spaced apart from the barrier wall PW when viewed from above the plane. That is, the first to third emission patterns EP1, EP2, and EP3 may not make contact with the first inner surfaces S-L1 of the first barrier wall layer L1.

According to the present disclosure, a plurality of first emission patterns EP1 may be subjected to patterning and deposited in pixel units by first tip portions TP1 defined in the barrier wall PW. That is, the first emission patterns EP1 may be commonly formed using an open mask, but may be easily divided from one another in pixel units by the barrier wall PW.

In contrast, in an example in which the first emission patterns EP1 are subjected to patterning using a fine metal mask (FMM), a spacer for support that protrudes from the conductive barrier wall has to be provided to support the fine metal mask. Furthermore, the fine metal mask may be spaced, by the height of the barrier wall and the spacer, apart from a base surface on which the patterning is performed, and therefore there may be a limitation in the implementation of high resolution. In some aspects, since the fine metal mask is brought into contact with the spacer, foreign matter may remain on the spacer after the patterning process of the first emission patterns EP1, or the spacer may be damaged by a dent in the fine metal mask. Accordingly, for example, a defective display panel may be formed.

According to this example embodiment, since the barrier wall PW is included, the physical separation between the light emitting elements ED1, ED2, and ED3 may be easily achieved. Accordingly, for example, current leakage or a driving error between the adjacent emissive regions PXA-R, PXA-G, and PXA-B may be prevented, and the light emitting elements ED1, ED2, and ED3 may be independently driven.

In particular, by patterning the plurality of first emission patterns EP1 without a mask in contact with an internal component in the display region DA (refer to FIG. 2), a defect rate may be reduced, and thus the display panel DP with improved process reliability may be provided. Since the patterning is possible even without the separate spacer for support that protrudes from the barrier wall PW, the areas of the emissive regions PXA-R, PXA-G, and PXA-B may be scaled down, and thus the display panel DP capable of easily implementing high resolution may be provided.

Furthermore, in the manufacture of the large-area display panel DP, the manufacture of a large-area mask may be omitted. Accordingly, for example, process costs may be reduced, and the display panel DP may not be affected by defects that are likely to occur in the large-area mask. Thus, the display panel DP with improved process reliability may be provided. The description of the plurality of first emission patterns EP1 may be identically applied to a plurality of second emission patterns EP2 and a plurality of third emission patterns EP3.

The auxiliary electrodes SE1, SE2, and SE3 may include the first auxiliary electrode SE1, the second auxiliary electrode SE2, and the third auxiliary electrode SE3. The first auxiliary electrode SE1 may be disposed on the first light emitting element ED1, the second auxiliary electrode SE2 may be disposed on the second light emitting element ED2, and the third auxiliary electrode SE3 may be disposed on the third light emitting element ED3. The first to third auxiliary electrodes SE1, SE2, and SE3 may extend along the first inner surfaces S-L1 (refer to FIG. 7) of the first barrier wall layer L1. The first to third auxiliary electrodes SE1, SE2, and SE3 may cover opposite ends of the first to third emission patterns EP1, EP2, and EP3 and opposite ends of the first to third cathodes CE1, CE2, and CE3.

The first to third auxiliary electrodes SE1, SE2, and SE3 may make contact with the first inner surfaces S-L1 of the first barrier wall layer L1 and may make contact with the first to third cathodes CE1, CE2, and CE3. That is, the first auxiliary electrode SE1 may be electrically connected with the first barrier wall layer L1 and the first cathode CE1, the second auxiliary electrode SE2 may be electrically connected with the first barrier wall layer L1 and the second cathode CE2, and the third auxiliary electrode SE3 may be electrically connected with the first barrier wall layer L1 and the third cathode CE3.

The first to third auxiliary electrodes SE1, SE2, and SE3 may be electrically connected with the first barrier wall layer L1 by making contact with the first barrier wall layer L1 and may receive a common voltage, and the first to third cathodes CE1, CE2, and CE3 may make contact with the first to third auxiliary electrodes SE1, SE2, and SE3 and may receive the common voltage.

The first auxiliary electrode SE1 may overlap the first light emitting opening OP1-E and may have a first thickness TH1. The second auxiliary electrode SE2 may overlap the second light emitting opening OP2-E and may have a second thickness TH2 different from the first thickness TH1. The third auxiliary electrode SE3 may overlap the third light emitting opening OP3-E and may have a third thickness TH3 different from the first thickness TH1 and the second thickness TH2. As described herein, the thicknesses of the first to third auxiliary electrodes SE1, SE2, and SE3 may vary based on the corresponding emissive regions PXA-R, PXA-G, and PXA-B.

The first thickness TH1 of the first auxiliary electrode SE1 may be a thickness by which the transmittance of red light emitted from the first light emitting element ED1 is highest (also referred to herein as maximal), for example, compared to other candidate thicknesses of the first auxiliary electrode SE1. The second thickness TH2 of the second auxiliary electrode SE2 may be a thickness by which the transmittance of green light emitted from the second light emitting element ED2 is highest (also referred to herein as maximal), for example, compared to other candidate thicknesses of the second auxiliary electrode SE2. The third thickness TH3 of the third auxiliary electrode SE3 may be a thickness by which the transmittance of blue light emitted from the third light emitting element ED3 is highest (also referred to herein as maximal), for example, compared to other candidate thicknesses of the third auxiliary electrode SE3. Aspects of the present disclosure support optimizing light transmittance by varying the thicknesses TH1, TH2, and TH3 of the first to third auxiliary electrodes SE1, SE2, and SE3 based on the wavelengths of the light emitted from the respective emissive regions PXA-R, PXA-G, and PXA-B as described herein.

Table 1 below illustrates the light transmittances of the auxiliary electrodes SE1, SE2, and SE3 based on the wavelengths of light when the thicknesses of the auxiliary electrodes SE1, SE2, and SE3 are varied. Here, the auxiliary electrodes SE1, SE2, and SE3 include indium zinc oxide.

**[Table 1]**

| Thickness of Auxiliary Electrode (Å) | Wavelength of Light (450 nm) | Wavelength of Light (550 nm) | Wavelength of Light (650 nm) |
|---|---|---|---|
| 300 | 81% | 89% | 93% |
| 450 | 77% | 83% | 88% |
| 550 | 78% | 81% | 85% |
| 650 | 79% | 82% | 86% |
| 900 | 95% | 87% | 85% |
| 1200 | 87% | 96% | 91% |

Referring to Table 1, in the case in which the wavelength of light is 450 nm, the light may be blue light. In the case in which the wavelength of light is 550 nm, the light may be green light. In the case in which the wavelength of light is 650 nm, the light may be red light.

In the case in which the wavelength of light is 450 nm, the light transmittance when the auxiliary electrodes have a thickness of 900 Å may be 95% that is a maximum value. In the case in which the wavelength of light is 550 nm, the light transmittance when the auxiliary electrodes have a thickness of 1200 Å may be 96% that is a maximum value. In the case in which the wavelength of light is 650 nm, the light transmittance when the auxiliary electrodes have a thickness of 300 Å may be 93% that is a maximum value.

Considering an error range of 15%, in the case in which the wavelength of light is 450 nm (in the case of blue light), according to one or more embodiments of the present disclosure, the auxiliary electrodes have a thickness of about 765 Å to about 1035 Å. In the case in which the wavelength of light is 550 nm (in the case of green light), according to one or more embodiments of the present disclosure, the auxiliary electrodes have a thickness of about 1020 Å to about 1380 Å. In the case in which the wavelength of light is 650 nm (in the case of red light), according to one or more embodiments of the present disclosure, the auxiliary electrodes have a thickness of about 255 Å to about 345 Å. That is, in an example in which the thicknesses of the auxiliary electrodes are differently set based on the wavelengths of light passing through the auxiliary electrodes, the luminances of the respective emissive regions may be equally maintained and the light transmittance is optimized at the same time.

Referring to Table 1 and FIGS. 9 to 10C, according to one or more embodiments of the present disclosure, the first thickness TH1 of the first auxiliary electrode SE1 through which red light transmits ranges from about 255 Å to about 345 Å. According to one or more embodiments of the present disclosure, the second thickness TH2 of the second auxiliary electrode SE2 through which green light transmits ranges from about 1020 Å to about 1380 Å. According to one or more embodiments of the present disclosure, the third thickness TH3 of the third auxiliary electrode SE3 through which blue light transmits ranges from about 765 Å to about 1035 Å. The third thickness TH3 may be greater than the first thickness TH1, and the second thickness TH2 may be greater than the third thickness TH3.

The second barrier wall layer L2 may include the first tip portion TP1, the second tip portion TP2, and the third tip portion TP3. The first tip portion TP1 may protrude from the first barrier wall layer L1 toward the first barrier wall opening OP1-P by a first protruding length TD1. The second tip portion TP2 may protrude from the first barrier wall layer L1 toward the second barrier wall opening OP2-P by a second protruding length TD2. The third tip portion TP3 may protrude from the first barrier wall layer L1 toward the third barrier wall opening OP3-P by a third protruding length TD3.

The first protruding length TD1 may be proportional to the first thickness TH1 of the first auxiliary electrode SE1. Accordingly, for example, embodiments of the present disclosure include preventing the thickness of the first auxiliary electrode SE1 from being excessively increased in comparison to the first protruding length TD1 of the first tip portion TP1. In an example in which the thickness of the first auxiliary electrode SE1 is excessively large in comparison to the first protruding length TD1, the first auxiliary electrode SE1 may be formed on the entire lower surface of the first tip portion TP1 in a sputtering process. An etchant for forming the dummy patterns DMP may be prevented from flowing to the first auxiliary electrode SE1 and the first cathode CE1. Descriptions thereof are provided herein with reference to FIGS. 12A to 12H. For the same reason as that applied to the first protruding length TD1, the second protruding length TD2 may be proportional to the second thickness TH2 of the second auxiliary electrode SE2. The third protruding length TD3 may be proportional to the third thickness TH3 of the third auxiliary electrode SE3. Descriptions herein of a characteristic (e.g., first protruding length TD1) being proportional to another characteristic (e.g., first thickness TH1 of the first auxiliary electrode SE1) may mean that the example aspects of the present disclosure support maintaining changes in the characteristic to be proportional to changes in the other characteristic. That is, for example, with respect to the characteristics, aspects of the methods include adjusting the first characteristic in proportion to adjustments to the other characteristic.

The first protruding length TD1 may range from about 0.4 µm to about 0.5 µm. If the first protruding length TD1 is less than about 0.4 µm, the first auxiliary electrode SE1 may be formed on the entire lower surface of the first tip portion TP1 when the first thickness TH1 of the first auxiliary electrode SE1 ranges from about 255 Å to about 345 Å, and therefore the first auxiliary electrode SE1 and the first cathode CE1 may be damaged as described herein. If the first protruding length TD1 exceeds about 0.5 µm, the amount of time to form the first region AA1-1 of the first barrier wall opening OP1-P in the first barrier wall layer L1 may exceed a target duration. Accordingly, for example, the first protruding length TD1 may preferably range from about 0.4 µm to about 0.5 µm.

The second protruding length TD2 may range from about 1.5 µm to about 1.8 µm. If the second protruding length TD2 is less than about 1.5 µm, the second auxiliary electrode SE2 may be formed on the entire lower surface of the second tip portion TP2 when the second thickness TH2 of the second auxiliary electrode SE2 ranges from about 1020 Å to about 1380 Å, and therefore the second auxiliary electrode SE2 and the second cathode CE2 may be damaged as described herein. If the second protruding length TD2 exceeds about 1.8 µm, the amount of time to form the first region AA1-2 of the second barrier wall opening OP2-P in the first barrier wall layer L1 may exceed a target duration. Accordingly, for example, the second protruding length TD2 may preferably range from about 1.5 µm to about 1.8 µm.

The third protruding length TD3 may range from about 1.0 µm to about 1.4 µm. If the third protruding length TD3 is less than about 1.0 µm, the third auxiliary electrode SE3 may be formed on the entire lower surface of the third tip portion TP3 when the third thickness TH3 of the third auxiliary electrode SE3 ranges from about 765 Å to about 1035 Å, and therefore the third auxiliary electrode SE3 and the third cathode CE3 may be damaged as described herein. If the third protruding length TD3 exceeds about 1.4 µm, the amount of time to form the first region AA1-3 of the third barrier wall opening OP3-P in the first barrier wall layer L1 may exceed a target duration. Accordingly, for example, the third protruding length TD3 may preferably range from about 1.0 µm to about 1.4 µm.

The third protruding length TD3 may be longer than the first protruding length TD1, and the second protruding length TD2 may be longer than the third protruding length TD3. This corresponds to the fact that the third thickness TH3 is greater than the first thickness TH1 and the second thickness TH2 is greater than the third thickness TH3.

The dummy patterns DMP may include a plurality of first dummy patterns D1, a plurality of second dummy patterns D2, and a plurality of third dummy patterns D3.

The first dummy patterns D1 may include a (1-1)th dummy pattern D11, a (2-1)th dummy pattern D21, and a (3-1)th dummy pattern D31 that surround the first to third emissive regions PXA-R, PXA-G, and PXA-B, respectively, when viewed from above the plane. The (1-1)th dummy pattern D11, the (2-1)th dummy pattern D21, and the (3-1)th dummy pattern D31 may include the same material as the first to third emission patterns EP1, EP2, and EP3 and may be formed through the same process as the first to third emission patterns EP1, EP2, and EP3.

The second dummy patterns D2 may include a (1-2)th dummy pattern D12, a (2-2)th dummy pattern D22, and a (3-2)th dummy pattern D32 that surround the first to third emissive regions PXA-R, PXA-G, and PXA-B, respectively, in an example in which viewed from above the plane. The (1-2)th dummy pattern D12, the (2-2)th dummy pattern D22, and the (3-2)th dummy pattern D32 may include the same material as the first to third cathodes CE1, CE2, and CE3 and may be formed through the same process as the first to third cathodes CE1, CE2, and CE3.

The third dummy patterns D3 may include a (1-3)th dummy pattern D13, a (2-3)th dummy pattern D23, and a (3-3)th dummy pattern D33 that surround the first to third emissive regions PXA-R, PXA-G, and PXA-B, respectively, when viewed from above the plane. The (1-3)th dummy pattern D13, the (2-3)th dummy pattern D23, and the (3-3)th dummy pattern D33 may include the same material as the first to third auxiliary electrodes SE1, SE2, and SE3 and may be formed through the same process as the first to third auxiliary electrodes SE1, SE2, and SE3.

First to third dummy openings OP1-D, OP2-D, and OP3-D corresponding to the first to third light emitting openings OP1-E, OP2-E, and OP3-E may be defined in the dummy patterns DMP.

The thin film encapsulation layer TFE may include lower inorganic encapsulation patterns LIL1, LIL2, and LIL3, the organic encapsulation film OL, and the upper inorganic encapsulation film UIL. In this example embodiment, the lower inorganic encapsulation patterns LIL1, LIL2, and LIL3 may include the first lower inorganic encapsulation pattern LIL1, the second lower inorganic encapsulation pattern LIL2, and the third lower inorganic encapsulation pattern LIL3. The first to third lower inorganic encapsulation patterns LIL1, LIL2, and LIL3 may overlap the first to third light emitting openings OP1-E, OP2-E, and OP3-E, respectively.

The first lower inorganic encapsulation pattern LIL1 may cover the first auxiliary electrode SE1, the (1-1)th dummy pattern D11, the (2-1)th dummy pattern D21, and the (3-1)th dummy pattern D31 and may be partially disposed in the first barrier wall opening OP1-P. The second lower inorganic encapsulation pattern LIL2 may cover the second auxiliary electrode SE2, the (1-2)th dummy pattern D12, the (2-2)th dummy pattern D22, and the (3-2)th dummy pattern D32 and may be partially disposed in the second barrier wall opening OP2-P. The third lower inorganic encapsulation pattern LIL3 may cover the third auxiliary electrode SE3, the (1-3)th dummy pattern D13, the (2-3)th dummy pattern D23, and the (3-3)th dummy pattern D33 and may be partially disposed in the third barrier wall opening OP3-P. The first to third lower inorganic encapsulation patterns LIL1, LIL2, and LIL3 may be provided in the form of patterns spaced apart from each other.

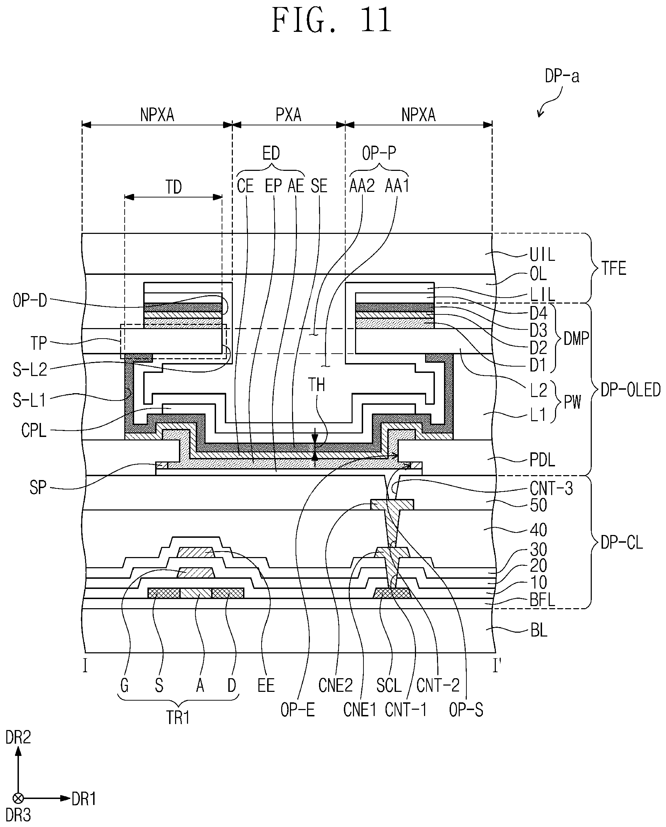

FIG. 11 is a sectional view of a display panel taken along line I-I' of FIG. 4 according to an embodiment of the present disclosure. The display panel DP-a of FIG. 11 is the same as the display panel DP of FIG. 7, except for a capping pattern CPL and a fourth dummy pattern D4. Therefore, descriptions of the same components will be omitted.

The display element layer DP-OLED may further include the capping pattern CPL. The capping pattern CPL may be disposed in the barrier wall opening OP-P. The capping pattern CPL may be disposed on the cathode CE or the auxiliary electrode SE. The capping pattern CPL may be subjected to patterning by the tip portion TP formed in the barrier wall PW. The capping pattern CPL may overlap the light emitting opening OP-P.

When the display element layer DP-OLED further includes the capping pattern CPL, the dummy patterns DMP may further include the fourth dummy pattern D4. The fourth dummy pattern D4 may include a conductive material. For example, the fourth dummy pattern D4 may include the same material as the capping pattern CPL. The fourth dummy pattern D4 may be simultaneously formed with the capping pattern CPL through one process and may be separated from the capping pattern CPL by the undercut shape of the barrier wall PW.

With reference to FIG. 9, the capping pattern CPL may be disposed on each of the first auxiliary electrode SE1 through third auxiliary electrode SE3. Expressed another way, the display element layer DP-OLED may include a first capping pattern CPL disposed on the first auxiliary electrode SE1, a second capping pattern CPL disposed on the second auxiliary electrode SE2, and a third capping pattern CPL disposed on the third auxiliary electrode SE3. The first capping pattern CPL may overlap the first light emitting opening OP1-E, the second capping pattern CPL may overlap the second light emitting opening OP2-E, and the third capping pattern CPL may overlap the third light emitting opening OP3-E.

FIGS. 12A to 12H are sectional views illustrating some of the steps of a method of manufacturing a display device according to an embodiment of the present disclosure. In describing FIGS. 12A to 12H, components identical or similar to the components described with reference to FIGS. 1 to 11 may be assigned with identical or similar reference numerals, and repetitive descriptions will be omitted.

Referring to FIG. 12A, the method of manufacturing a display device according to this example embodiment may include a step of providing a preliminary display panel DP-I. The preliminary display panel DP-I provided in this example embodiment may include the base layer BL, the circuit element layer DP-CL, the first to third anodes AE1, AE2, and AE3, first to third preliminary sacrificial patterns SP1-I, SP2-I, and SP3-I, the pixel defining layer PDL, a first preliminary barrier wall layer L1-I, and a second preliminary barrier wall layer L2-I.

The circuit element layer DP-CL may be formed through a conventional circuit element manufacturing process of forming an insulating layer, a semiconductor layer, and a conductive layer by coating, deposition, or the like and forming a semiconductor pattern, a conductive pattern, and a signal line by selectively patterning the insulating layer, the semiconductor layer, and the conductive layer by photolithography and etching processes.

The method may include forming the first anode AE1 and the first preliminary sacrificial pattern SP1-I by the same patterning process, and the method may include forming the second anode AE2 and the second preliminary sacrificial pattern SP2-I by the same patterning process. The method may include disposing the pixel defining layer PDL over the base layer BL. The pixel defining layer PDL may cover both the first and second anodes AE1 and AE2 and the first and second preliminary sacrificial patterns SP1-I and SP2-I.

The first preliminary barrier wall layer L1-I may be disposed on the pixel defining layer PDL. The method may include forming the first preliminary barrier wall layer L1-I by a process of depositing a conductive material. The second preliminary barrier wall layer L2-I may be disposed on the first preliminary barrier wall layer L1-I. The method may include forming the second preliminary barrier wall layer L2-I by a process of depositing a conductive material. In this example embodiment, the first preliminary barrier wall layer L1-I may include aluminium (Al) or molybdenum (Mo), and the second preliminary barrier wall layer L2-I may include titanium (Ti). However, the materials of the first preliminary barrier wall layer L1-I and the second preliminary barrier wall layer L2-I are not limited thereto. The first preliminary barrier wall layer L1-I and the second preliminary barrier wall layer L2-I may form a preliminary barrier wall PW-I.

The method of manufacturing a display device according to this example embodiment may include a step of forming a first photoresist layer PR1 on the preliminary barrier wall PW-I. The method may include forming the first photoresist layer PR1 by forming a preliminary photoresist layer on the preliminary barrier wall PW-I and thereafter patterning the preliminary photoresist layer using a photo mask. Through the patterning process, a first photo opening OP-PR1 may be formed in the first photoresist layer PR1. The first photo opening OP-PR1 may overlap the first anode AE1.

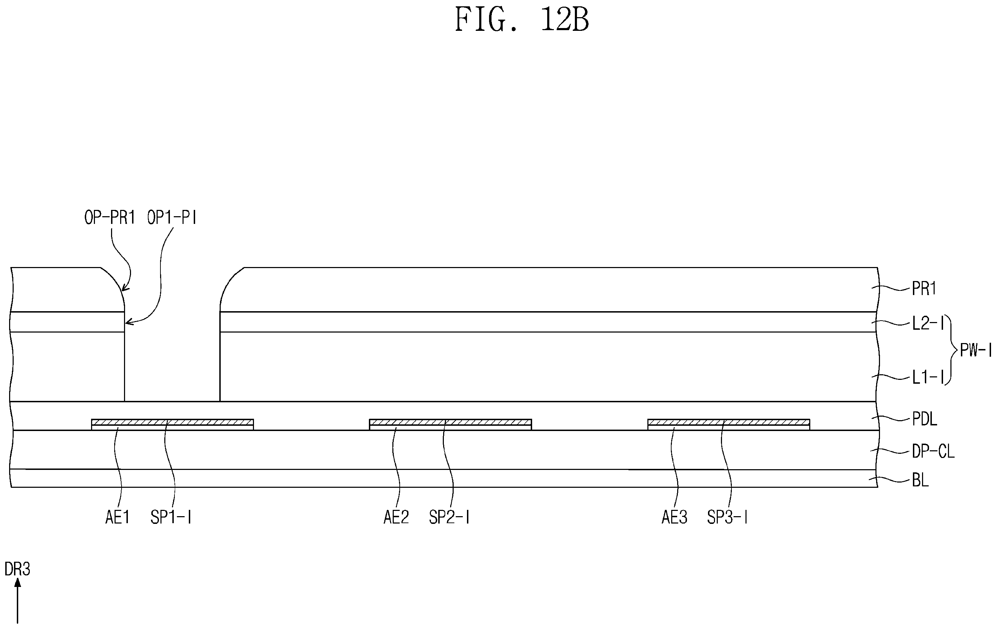

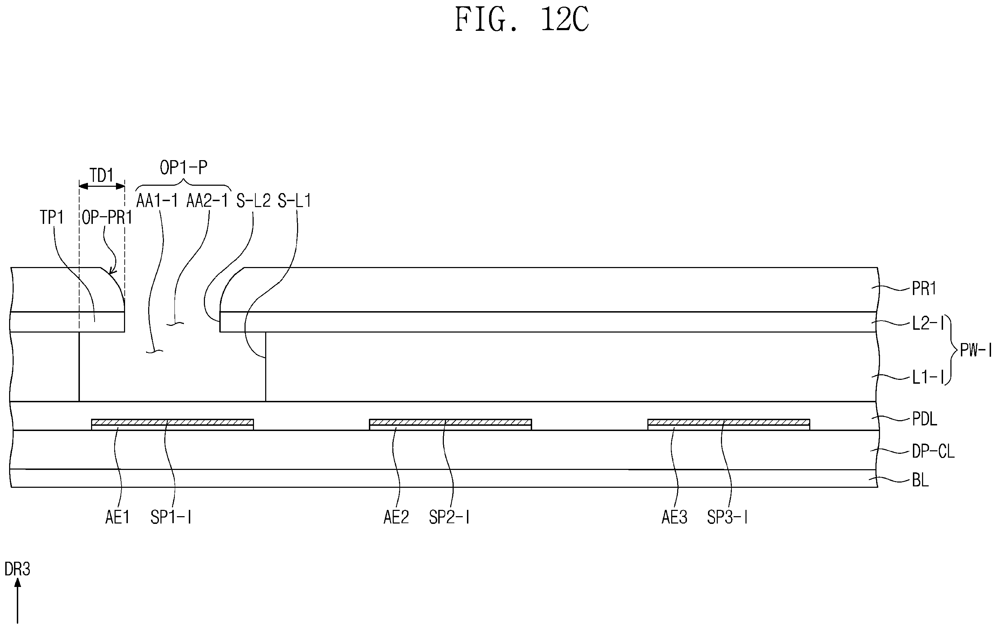

Referring to FIGS. 12B and 12C, the method of manufacturing a display device according to this example embodiment may include a step of forming the barrier wall opening OP1-P and the first tip portion TP1 of the second preliminary barrier wall layer L2-I, which protrudes from the first preliminary barrier wall layer L1-I toward the first barrier wall opening OP1-P, by etching the first preliminary barrier wall layer L1-I and the second preliminary barrier wall layer L2-I.

As illustrated in FIG. 12B, in the step of etching the first preliminary barrier wall layer L1-I and the second preliminary barrier wall layer L2-I, the method may include forming a first preliminary barrier wall opening OP1-PI in the preliminary barrier wall PW-I (refer to FIG. 12B) by dry etching the first preliminary barrier wall layer L1-I and the second preliminary barrier wall layer L2-I using the first photoresist layer PR1 as a mask.

This example embodiment may include performing the first dry etching process in an etching environment in which the etch selectivity between the first preliminary barrier wall layer L1-I and the second preliminary barrier wall layer L2-I is substantially the same. Accordingly, for example, the inner surface of the first preliminary barrier wall layer L1-I and the inner surface of the second preliminary barrier wall layer L2-I that define the first preliminary barrier wall opening OP1-PI may be substantially aligned with each other.

As illustrated in FIG. 12C, the method may include a step of secondly etching the first preliminary barrier wall layer L1-I (refer to FIG. 12B) which may include a step of forming the first barrier wall opening OP1-P from the first preliminary barrier wall opening OP1-PI (refer to FIG. 12B) by wet etching the first preliminary barrier wall layer L1-I using the first photoresist layer PR1 as a mask.

The first barrier wall opening OP1-P may include the first region AA1-1 and the second region AA2-1 sequentially disposed in the thickness direction (that is, the third direction DR3). The first preliminary barrier wall layer L1-I may include the first inner surface S-L1 that defines the first region AA1-1 of the first barrier wall opening OP1-P, and the second preliminary barrier wall layer L2-I may include the second inner surface S-L2 that defines the second region AA2-1 of the first barrier wall opening OP1-P.

Referring to FIG. 12C, the method may include forming the first tip portion TP1 protruding from the first preliminary barrier wall layer L1-I toward the first barrier wall opening OP1-P. The method may include forming the first tip portion TP1 in the second preliminary barrier wall layer L2-I. The wet etching process in this example embodiment may be performed in an environment in which the etch selectivity between the first preliminary barrier wall layer L1-I and the second preliminary barrier wall layer L2-I is large. Accordingly, for example, the inner surface of the barrier wall PW that defines the first barrier wall opening OP1-P may have an undercut shape on the section. Specifically, for example, the etch rate of the first preliminary barrier wall layer L1-I by an etchant is higher than the etch rate of the second preliminary barrier wall layer L2-I by the etchant, and based on the difference in etch rates, the first preliminary barrier wall layer L1-I may be mainly etched by the wet etching process.

Accordingly, for example, the first inner surfaces S-L1 of the first preliminary barrier wall layer L1-I may be recessed inward in comparison to the second inner surfaces S-L2 of the second preliminary barrier wall layer L2-I. The first tip portion TP1 formed in the preliminary barrier wall PW-I may be formed by the portion of the second preliminary barrier wall layer L2-I that protrudes in comparison to the first preliminary barrier wall layer L1-I.

The first protruding length TD1 of the first tip portion TP1 of the second preliminary barrier wall layer L2-I may be the length between the first inner surface S-L1 of the first preliminary barrier wall layer L1-I and the second inner surface S-L2 of the second preliminary barrier wall layer L2-I that overlap the pixel defining layer PDL. The method may support adjusting the first protruding length TD1 of the first tip portion TP1 by adjusting the time period during which the first preliminary barrier wall layer L1-I is exposed to the etchant in the wet etching process. That is, in an example in which the first preliminary barrier wall layer L1-I is exposed to the etchant for a long time, the first preliminary barrier wall layer L1-I may be greatly etched, and thus the first protruding length TD1 may be large. Expressed another way, the amount in which the first preliminary barrier wall layer L1-I is etched (and accordingly, for example, the first protruding length TD1) may be based on the amount of time in which the preliminary barrier wall layer L1-I is exposed to the etchant.

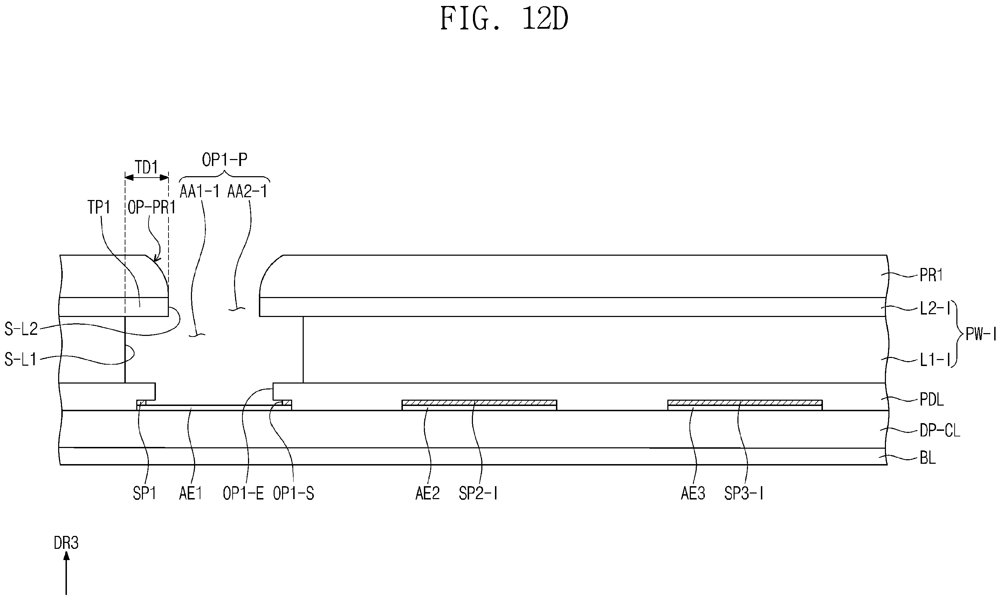

Referring to FIG. 12D, the method may include etching the pixel defining layer PDL and etching the first preliminary sacrificial pattern SP1-I (refer to FIG. 12C). The etching of the pixel defining layer PDL may be performed by a dry etching process. The method may include etching the pixel defining layer PDL using the first photoresist layer PR1 and the preliminary barrier wall PW-I as a mask. The first light emitting opening OP1-E corresponding to the first barrier wall opening OP1-P may be formed in the pixel defining layer PDL based on the etching.

The method may include performing the etching of the first preliminary sacrificial pattern SP1-I by a wet etching process. The method may include etching the first preliminary sacrificial pattern SP1-I using the first photoresist layer PR1 and the preliminary barrier wall PW-I as a mask. The method may include forming the first sacrificial opening OP1-S overlapping the first light emitting opening OP1-E in the first sacrificial pattern SP1 formed by etching the first preliminary sacrificial pattern SP1-I.

The first sacrificial opening OP1-S overlapping the first light emitting opening OP1-E may be formed in the first sacrificial pattern SP1. At least a portion of the first anode AE1 may be exposed from the first sacrificial pattern SP1 and the pixel defining layer PDL by the first sacrificial opening OP1-S and the first light emitting opening OP1-E.

The method may include performing the etching process of the first sacrificial pattern SP1 in an environment in which the etch selectivity between the first sacrificial pattern SP1 and the first anode AE1 is large. Accordingly, for example, embodiments of the present disclosure include preventing the first anode AE1 and the first sacrificial pattern SP1 from being etched together.

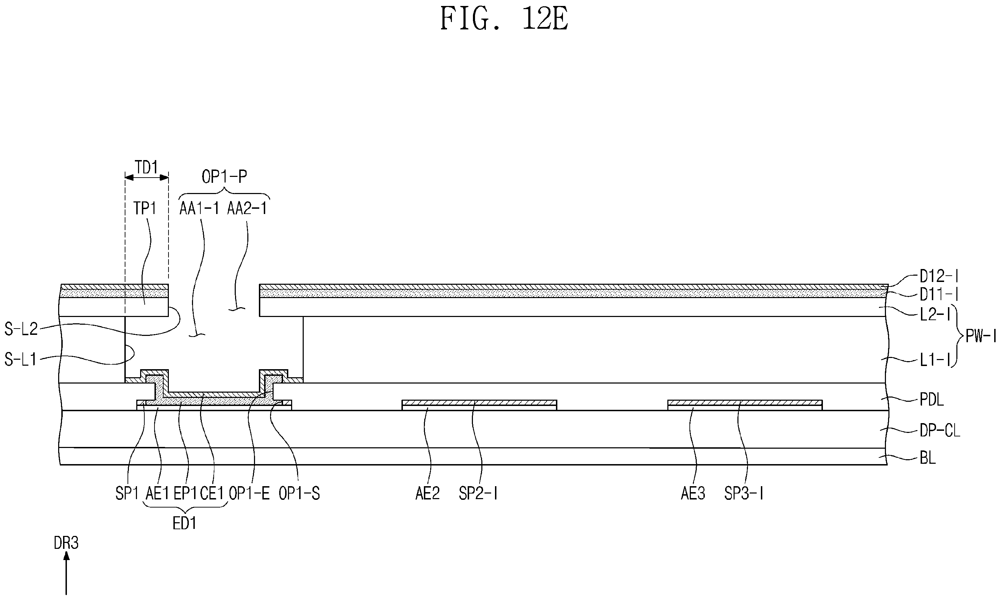

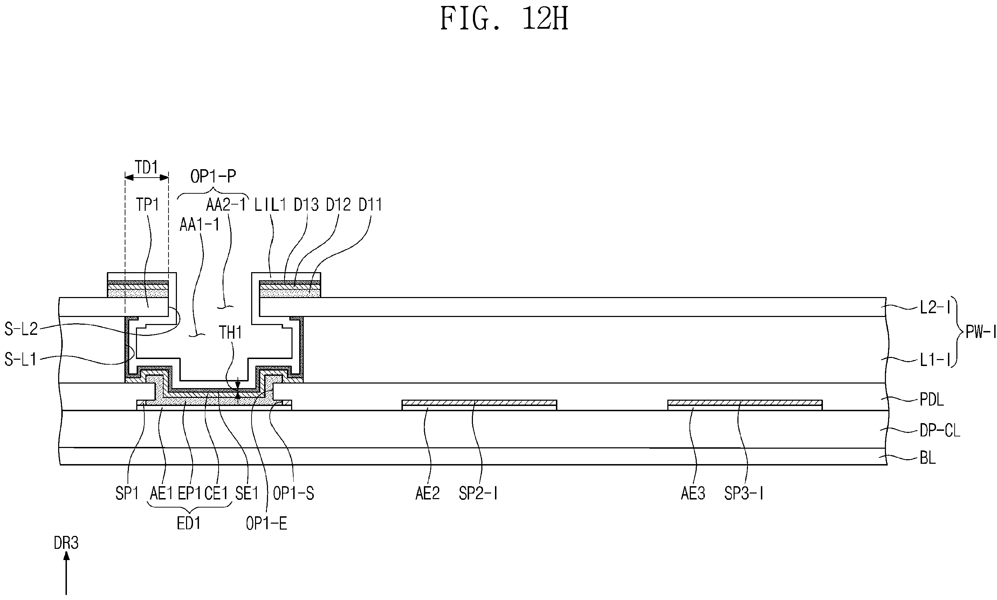

Referring to FIGS. 12E and 12H, the method of manufacturing a display device according to this example embodiment may include a step of forming the first emission pattern EP1 (or, the emission pattern) and the first cathode CE1 (or, the cathode) in the first barrier wall opening OP1-P after removing the first photoresist layer PR1 (refer to FIG. 12D) and a step of forming the first auxiliary electrode SE1 (or, the auxiliary electrode).

Referring to FIG. 12E, the method may include forming the first emission pattern EP1 and the first cathode CE1 through a thermal evaporation process.

The method may include forming the first emission pattern EP1 on the first anode AE1. In an example in which the first emission pattern EP1 is formed, the first emission pattern EP1 may be separated from a preliminary (1-1)th dummy pattern D11-I by the first tip portion TP1 formed in the preliminary barrier wall PW-I. The first emission pattern EP1 may be disposed in the first light emitting opening OP1-E and the first barrier wall opening OP1-P. In the step of forming the first emission pattern EP1, the (1-1)th preliminary dummy layer D11-I spaced apart from the first emission pattern EP1 may be formed together on the preliminary barrier wall PW-I.

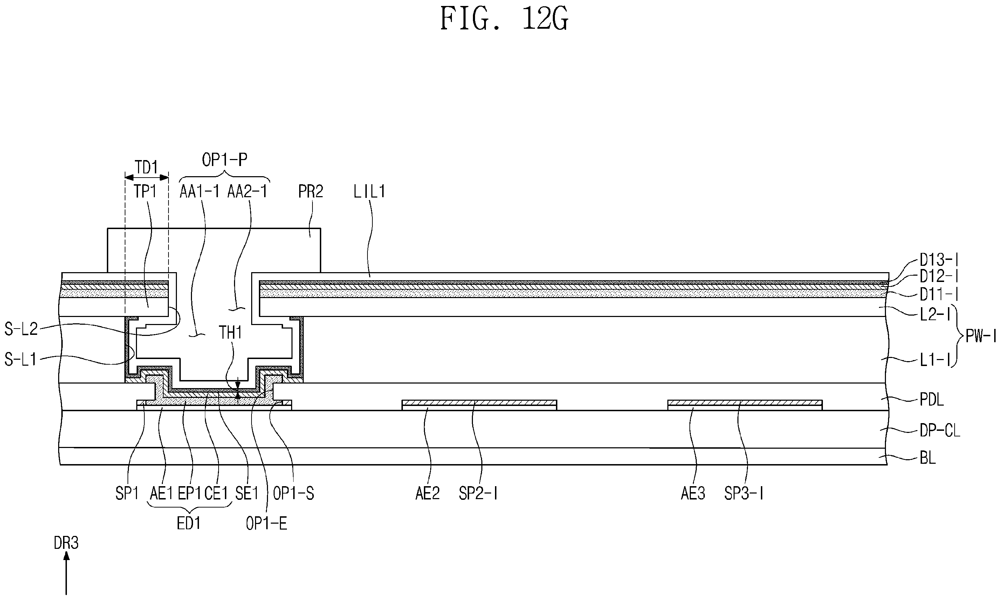

The method may include forming the first cathode CE1 on the first emission pattern EP1. The first cathode CE1 may be separated from a preliminary (1-2)th dummy pattern D12-I by the first tip portion TP1 formed in the preliminary barrier wall PW-I. The first cathode CE1 may be disposed in the first barrier wall opening OP1-P. In the step of forming the first cathode CE1, the (1-2)th preliminary dummy layer D12-I spaced apart from the first cathode CE1 may be formed together on the preliminary barrier wall PW-I. Accordingly, for example, FIG. 12G illustrates an example of forming the first light emitting element ED1.

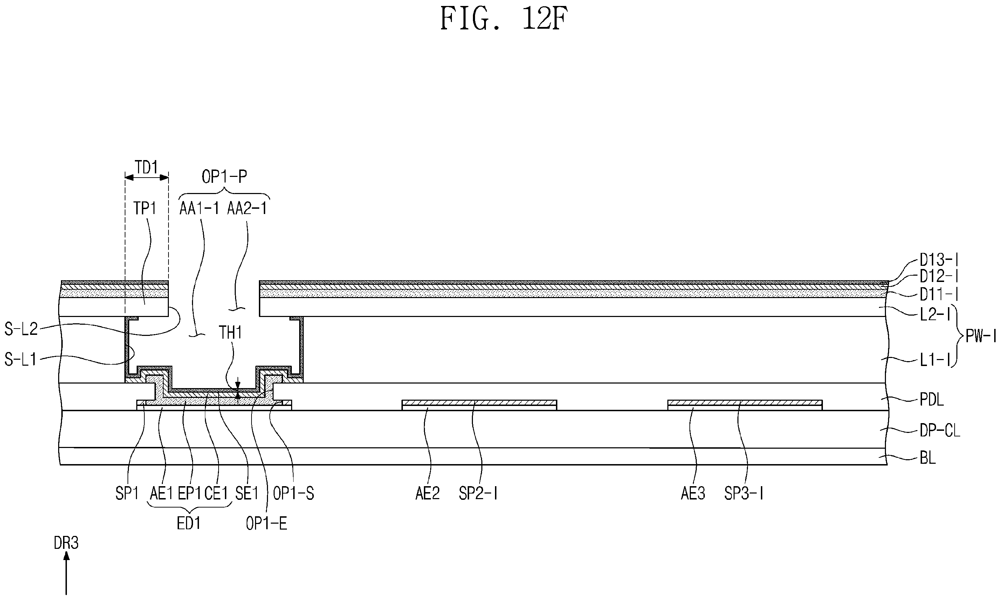

Referring to FIG. 12F, the method may include forming the first auxiliary electrode SE1 in the first barrier wall opening OP1-P. In the example, the first auxiliary electrode SE1 is disposed on the first light emitting element ED1 and has the first thickness TH1.

The first auxiliary electrode SE1 may be disposed on the first cathode CE1 and may cover the first cathode CE1. The first auxiliary electrode SE1 may be separated from a (1-3)th preliminary dummy layer D13-I by the first tip portion TP1 formed in the preliminary barrier wall PW-I. The first auxiliary electrode SE1 may be deposited such that the first auxiliary electrode SE1 covers the opposite ends of the first emission pattern EP1 and the opposite ends of the first cathode CE1. In the step of forming the first auxiliary electrode SE1, the (1-3)th preliminary dummy layer D13-I spaced apart from the first auxiliary electrode SE1 may be formed together on the preliminary barrier wall PW-I.

In an embodiment, the method may include forming the first auxiliary electrode SE1 through a sputtering process. The method may include forming the first auxiliary electrode SE1 such that the first auxiliary electrode SE1 makes contact with the preliminary first barrier wall layer L1-I. The first auxiliary electrode SE1 may extend along the first inner surface S-L1 of the preliminary first barrier wall layer L1-I. The first auxiliary electrode SE1 may extend along a portion of the lower surface of the first tip portion TP1.

The first thickness TH1 of the first auxiliary electrode SE1 may be proportional to the first protruding length TD1. If the first thickness TH1 is excessively large in comparison to the first protruding length TD1, the first auxiliary electrode SE1 may extend along the side surface of the preliminary second barrier wall layer L2-I and the lower surface of the first tip portion TP1 in the sputtering process and may not be separated from the (1-3)th preliminary dummy layer D13-I. In this case, in an etching step of FIG. 12H, an etchant may flow to the first auxiliary electrode SE1 through the (1-3)th dummy pattern D13 (refer to FIG. 12H). Therefore, the first auxiliary electrode SE1 and the first cathode CE1 making contact with the first auxiliary electrode SE1 may be damaged. To prevent this, aspects of the method include adjusting the first protruding length TD1 in proportion to the first thickness TH1. For example, aspects of the method include increasing the first protruding length TD1 in proportion to the first thickness TH1.

Referring to FIG. 12G, the method may include forming the first lower inorganic encapsulation layer LIL1 that covers the first light emitting element ED1 and the first auxiliary electrode SE1. The method may include forming the first lower inorganic encapsulation layer LIL1 through a deposition process. In an embodiment, the method may include forming the first lower inorganic encapsulation layer LIL1 through a chemical vapor deposition (CVD) process. The first lower inorganic encapsulation layer LIL1 may be formed on the preliminary barrier wall PW-I and the first auxiliary electrode SE1.

Thereafter, the method may include forming a second photoresist layer PR2. In the step of forming the second photoresist layer PR2, the second photoresist layer PR2 may be formed by forming a preliminary photoresist layer and patterning the preliminary photoresist layer using a photo mask. Through the patterning process, the second photoresist layer PR2 may be formed in the form of a pattern corresponding to the first light emitting opening OP1-E.

Referring to FIG. 12H, the method may include patterning the (1-1)th preliminary dummy layer D11-I, the (1-2)th preliminary dummy layer D12-I, the preliminary (1-3)th preliminary dummy layer D13-I, and the first lower inorganic encapsulation layer LIL1.

The patterning of the first lower inorganic encapsulation layer LIL1 may include removing the portion of the first lower inorganic encapsulation layer LIL1 that does not overlap the second photoresist layer PR2 by dry etching the first lower inorganic encapsulation layer LIL1. The patterned first lower inorganic encapsulation layer LIL1 may overlap the first light emitting opening OP1-E.

The patterning of the (1-3)th preliminary dummy layer D13-I (refer to FIG. 12G) may include removing the portion of the (1-3)th preliminary dummy layer D13-I (refer to FIG. 12G) that does not overlap the second photoresist layer PR2 by dry etching the (1-3)th preliminary dummy layer D13-I (refer to FIG. 12G).

The patterning of the (1-2)th preliminary dummy layer D12-I (refer to FIG. 12G) and the (1-1)th preliminary dummy layer D11-I (refer to FIG. 12G) may include using wet etching. The patterning may include removing portions of the (1-2)th preliminary dummy layer D12-I (refer to FIG. 12G) and the (1-1)th preliminary dummy layer D11-I (refer to FIG. 12G) that do not overlap the second photoresist layer PR2. At this time, the etchant may not flow to the first auxiliary electrode SE1 because the first auxiliary electrode SE1 does not overlap at least a portion of the lower surface of the first tip portion TP1 and is separated from the (1-3)th dummy pattern D13.

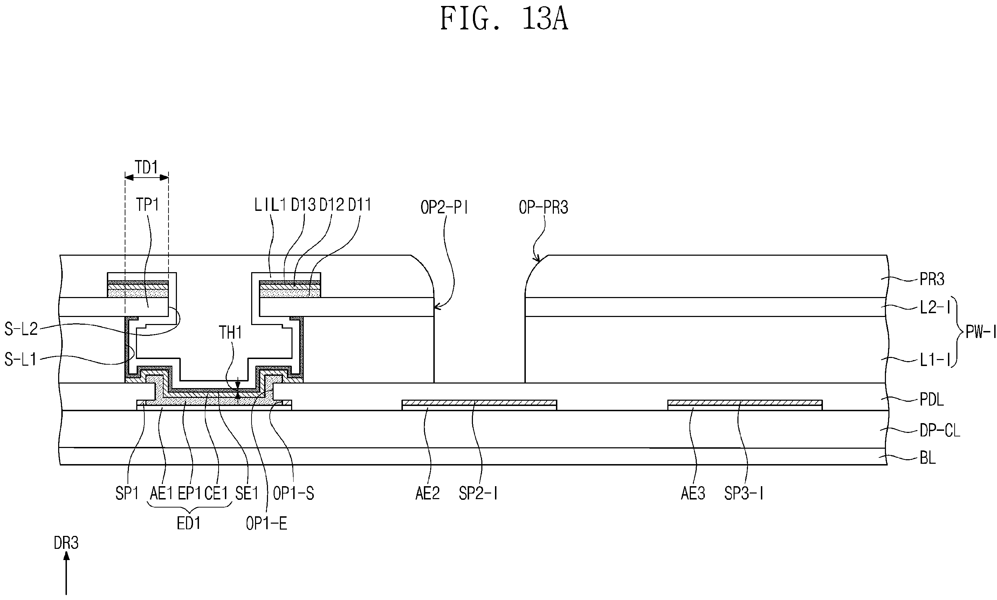

FIGS. 13A to 13E are sectional views illustrating some of the steps of the method of manufacturing a display device according to an embodiment of the present disclosure. In describing FIGS. 13A to 13E, components identical or similar to the components described with reference to FIGS. 1 to 12H may be assigned with identical or similar reference numerals, and repetitive descriptions will be omitted.

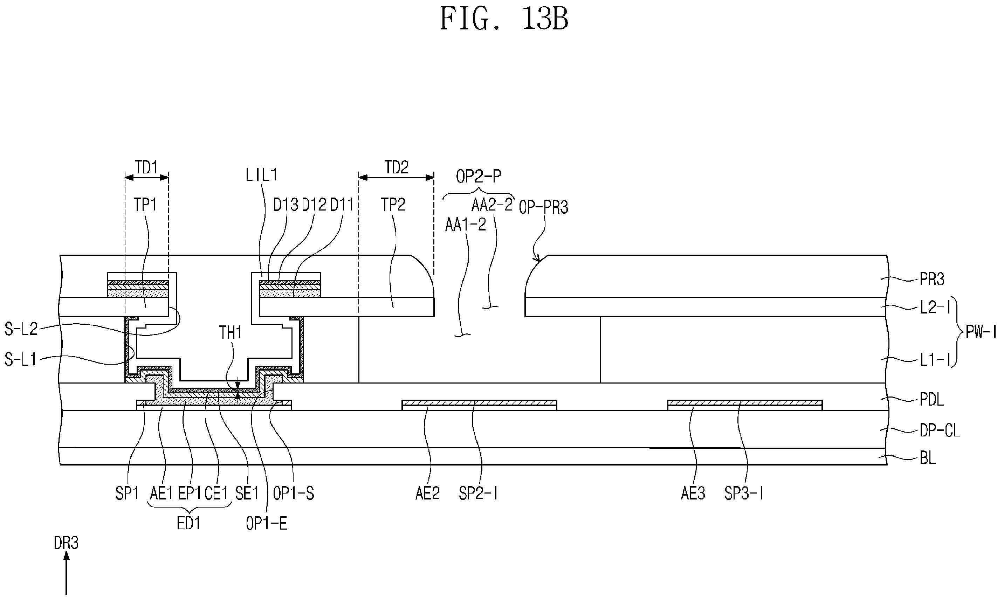

Referring to FIGS. 13A and 13B, the method may include forming a third photoresist layer PR3 on the preliminary barrier wall PW-I. The method may include forming, through a patterning process, a third photo opening OP-PR3 in the third photoresist layer PR3. The third photo opening OP-PR3 may overlap the second anode AE2.

According to the method, the second barrier wall opening OP2-P and the second tip portion TP2 of the second preliminary barrier wall layer L2-I, which protrudes from the second preliminary barrier wall layer L2-I toward the second barrier wall opening OP2-P, may be formed by etching the first preliminary barrier wall layer L1-I and the second preliminary barrier wall layer L2-I.

As illustrated in FIG. 13A, in the step of etching the first preliminary barrier wall layer L1-I and the second preliminary barrier wall layer L2-I, the method may include forming a second preliminary barrier wall opening OP2-PI in the preliminary barrier wall PW-I by dry etching the first preliminary barrier wall layer L1-I and the second preliminary barrier wall layer L2-I using the third photoresist layer PR3 as a mask. Here, the dry etching process is the same as the dry etching process described with reference to FIG. 12B, and therefore repeated detailed descriptions with respect to the dry etching process are omitted for brevity.

As illustrated in FIG. 13B, the method may include a step of secondly etching the first preliminary barrier wall layer L1-I. The step of secondly etching the first preliminary barrier wall layer L1-I may include a step of forming the second barrier wall opening OP2-P from the second preliminary barrier wall opening OP2-PI (refer to FIG. 13A) by wet etching the first preliminary barrier wall layer L1-I using the third photoresist layer PR3 as a mask.

The second barrier wall opening OP2-P may include the first region AA1-2 and the second region AA2-2 sequentially disposed in the thickness direction (that is, the third direction DR3).

Furthermore, referring to FIG. 13B, the method may include forming, in the second preliminary barrier wall layer L2-I, the second tip portion TP2 which protrudes from the first preliminary barrier wall layer L1-I toward the second barrier wall opening OP2-P.

The second protruding length TD2 of the second tip portion TP2 of the second preliminary barrier wall layer L2-I may be the length between the first inner surface S-L1 of the first preliminary barrier wall layer L1-I and the second inner surface S-L2 of the second preliminary barrier wall layer L2-I that overlap the pixel defining layer PDL. The method supports adjusting the second protruding length TD2 of the second tip portion TP2 by adjusting the time period during which the second preliminary barrier wall layer L2-I is exposed to an etchant in the wet etching process. For example, the time period during which the second preliminary barrier wall layer L2-I (refer to FIG. 12C) is exposed to the etchant in the wet etching process of FIG. 12C may be shorter than the a time period during which the second preliminary barrier wall layer L2-I is exposed to the etchant in the wet etching process of FIG. 13B. Accordingly, for example, the second protruding length TD2 of the second tip portion TP2 may be longer than the first protruding length TD1 of the first tip portion TP1. In some aspects, the etchant in the wet etching process of FIG. 12C may be the same or different from the etchant in the wet etching process of FIG. 13B.

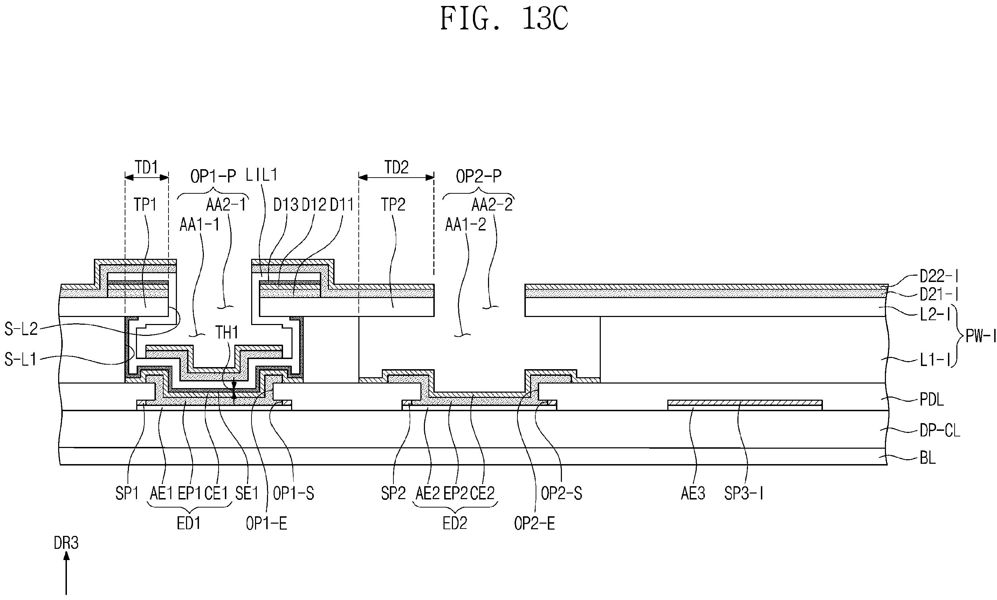

Referring to FIG. 13C, the method may include etching the pixel defining layer PDL and etching the second preliminary sacrificial pattern SP2-I (refer to FIG. 13B). The method may include forming, in the pixel defining layer PDL, the second light emitting opening OP2-E corresponding to the second barrier wall opening OP2-P. The method may include forming the second sacrificial opening OP2-S overlapping the second light emitting opening OP2-E in the second sacrificial pattern SP2 formed by etching the second preliminary sacrificial pattern SP2-I (refer to FIG. 13B).

Thereafter, the method may include removing the third photoresist layer PR3, and the method may include forming the second emission pattern EP2 (or, the emission pattern), the second cathode CE2 (or, the cathode), and the second auxiliary electrode SE2 (or, the auxiliary electrode) in the second barrier wall opening OP2-P. The method may include forming the second emission pattern EP2 and the second cathode CE2 through a thermal evaporation process. In the step of forming the second emission pattern EP2 and the second cathode CE2, a (2-1)th preliminary dummy layer D21-I spaced apart from the second emission pattern EP2 and a (2-2)th preliminary dummy layer D22-I spaced apart from the second cathode CE2 may be formed together on the preliminary barrier wall PW-I. Accordingly, for example, FIG. 13C illustrates an example of forming the second light emitting element ED2.

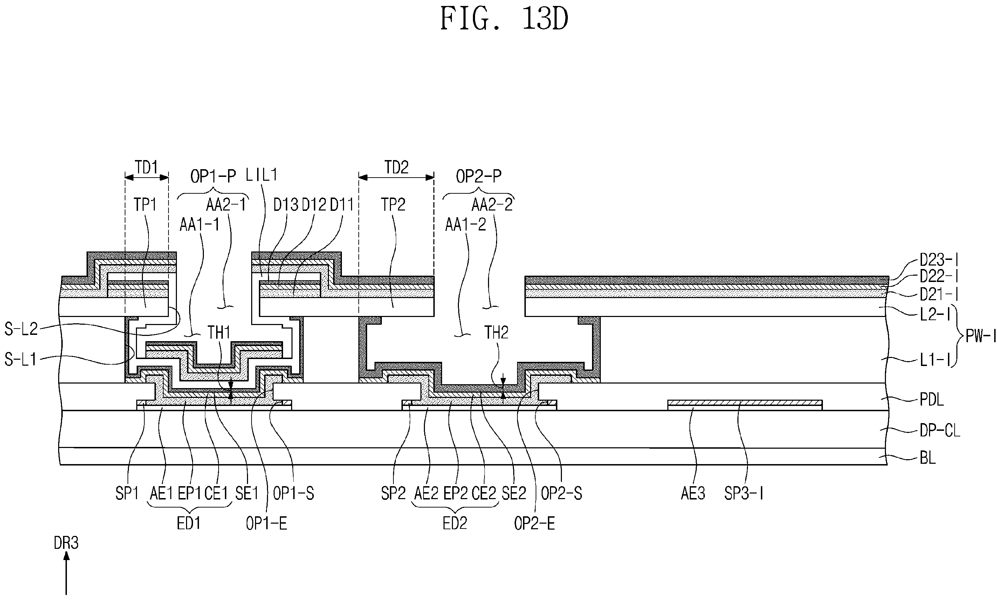

Referring to FIG. 13D, the method may include forming, in the second barrier wall opening OP2-P, the second auxiliary electrode SE2 that is disposed on the second light emitting element ED2 and that has the second thickness TH2. The method may include forming the second auxiliary electrode SE2 through a sputtering process. The method may include forming the second auxiliary electrode SE2 such that the second auxiliary electrode SE2 is in contact with the preliminary first barrier wall layer L1-I. The second auxiliary electrode SE2 may extend along the first inner surface S-L1 of the preliminary first barrier wall layer L1-I. The second auxiliary electrode SE2 may extend along a portion of the lower surface of the second tip portion TP2.

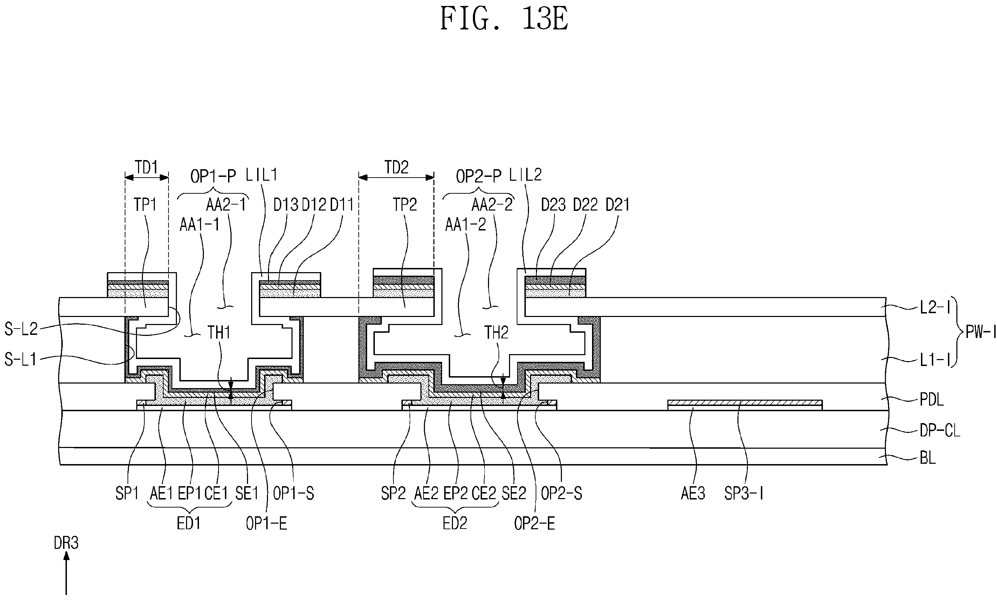

The second thickness TH2 of the second auxiliary electrode SE2 may be proportional to the second protruding length TD2. If the second thickness TH2 is excessively large in comparison to the second protruding length TD2, the second auxiliary electrode SE2 may extend along the side surface of the preliminary second barrier wall layer L2-I and the lower surface of the second tip portion TP2 in the sputtering process and may not be separated from a (2-3)th preliminary dummy layer D23-I. In this case, in an etching step of FIG. 13E, an etchant may flow to the second auxiliary electrode SE2 through the (2-3)th dummy pattern D23 (refer to FIG. 13E). Accordingly, for example, the second auxiliary electrode SE2 and the second cathode CE2 in contact with the second auxiliary electrode SE2 may be damaged. To prevent this, aspects of the method include adjusting the second protruding length TD2 in proportion to the second thickness TH2. For example, aspects of the method include increasing the second protruding length TD2 in proportion to the second thickness TH2.

In the step of forming the second auxiliary electrode SE2, the (2-3)th preliminary dummy layer D23-I spaced apart from the second auxiliary electrode SE2 may be formed together on the preliminary barrier wall PW-I.

Referring to FIG. 13E, the method may include forming the second lower inorganic encapsulation layer LIL2. Thereafter, the method may include patterning the (2-1)th through (2-3)th preliminary dummy layers D21-I, D22-I, and D23-I (refer to FIG. 13D) and the second lower inorganic encapsulation layer LIL2.

The patterning of the second lower inorganic encapsulation layer LIL2 may include dry etching the second lower inorganic encapsulation layer LIL2. In an example of patterning the (2-3)th preliminary dummy layer D23-I (refer to FIG. 13D), the method may include dry etching the (2-3)th preliminary dummy layer D23-I (refer to FIG. 13D). In an example of patterning the (2-2)th preliminary dummy layer D22-I (refer to FIG. 13D) and the (2-1)th preliminary dummy layer D21-I (refer to FIG. 13D), the method may include wet etching the (2-2)th preliminary dummy layer D22-I and the (2-1)th preliminary dummy layer D21-I.

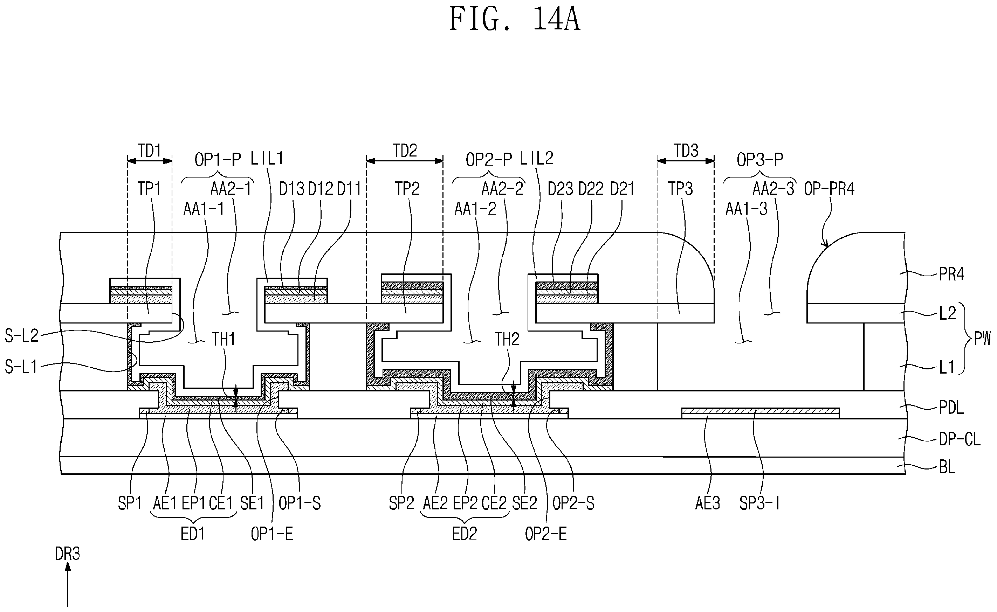

FIGS. 14A to 14C are sectional views illustrating some of the steps of the method of manufacturing a display device according to an embodiment of the present disclosure.

Referring to FIG. 14A, the method may include forming the barrier wall PW including the first barrier wall layer L1 and the second barrier wall layer L2 by etching the first preliminary barrier wall layer L1-I (refer to FIG. 13E) and the second preliminary barrier wall layer L2-I (refer to FIG. 13E) using a fourth photoresist layer PR4 having a fourth photo opening OP-PR4 defined therein as a mask. A detailed process is the same as the etching process described with reference to FIGS. 12A to 12C, and repeated detailed descriptions with respect to the etching process are omitted for brevity.

The method supports adjusting the third protruding length TD3 of the third tip portion TP3 by adjusting the time period during which the second preliminary barrier wall layer L2-I (refer to FIG. 13E) is exposed to an etchant in a wet etching process. For example, the time period during which the second preliminary barrier wall layer L2-I (refer to FIG. 13B) is exposed to the etchant in the wet etching process of FIG. 13B may be longer than the a time period during which the second preliminary barrier wall layer L2-I is exposed to the etchant in the wet etching process of FIG. 14A. Accordingly, for example, the second protruding length TD2 of the second tip portion TP2 may be longer than the third protruding length TD3 of the third tip portion TP3. In some aspects, the etchant in the wet etching process of FIG. 13B may be the same or different from the etchant in the wet etching process of FIG. 14A.

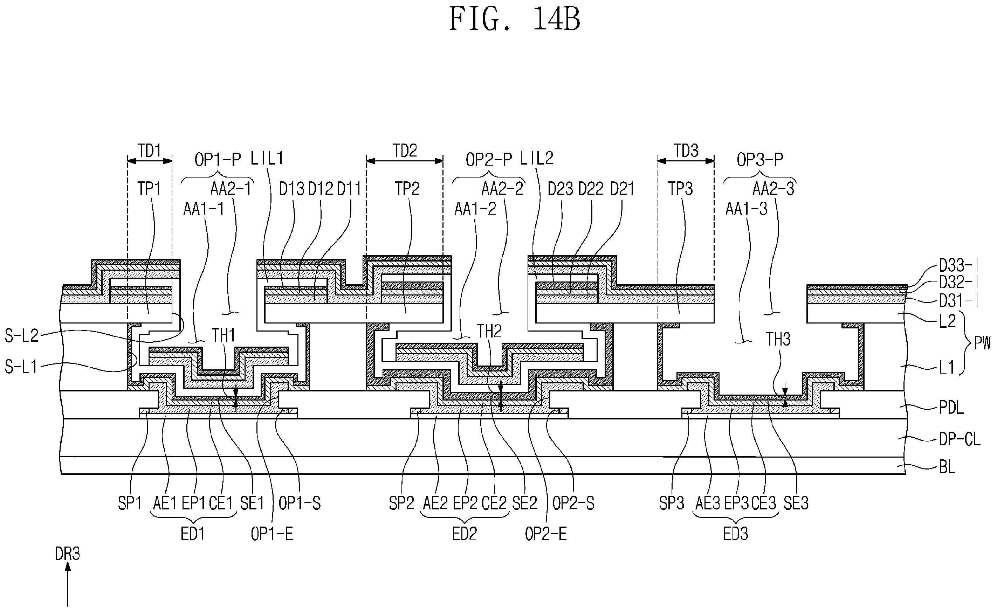

Referring to FIG. 14B, the method may include etching the pixel defining layer PDL and etching the third preliminary sacrificial pattern SP3-I (refer to FIG. 14A). The method may include forming, in the pixel defining layer PDL, the third light emitting opening OP3-E corresponding to the third barrier wall opening OP3-P. The method may include forming the third sacrificial opening OP3-S overlapping the third light emitting opening OP3-E in the third sacrificial pattern SP3 formed by etching the third preliminary sacrificial layer SP3-I (refer to FIG. 14A).

Thereafter, the method may include forming the third emission pattern EP3 (or, the emission pattern), the third cathode CE3 (or, the cathode), and the third auxiliary electrode SE3 (or, the auxiliary electrode) in the third barrier wall opening OP3-P. The method may include forming the third emission pattern EP3 and the third cathode CE3 through a thermal evaporation process. The method may include forming the third auxiliary electrode SE3 through a sputtering process. Detailed processes are performed in the same manner as the processes described herein with reference to FIGS. 12E and 12F, and therefore repeated detailed descriptions with respect to the processes are omitted for brevity.

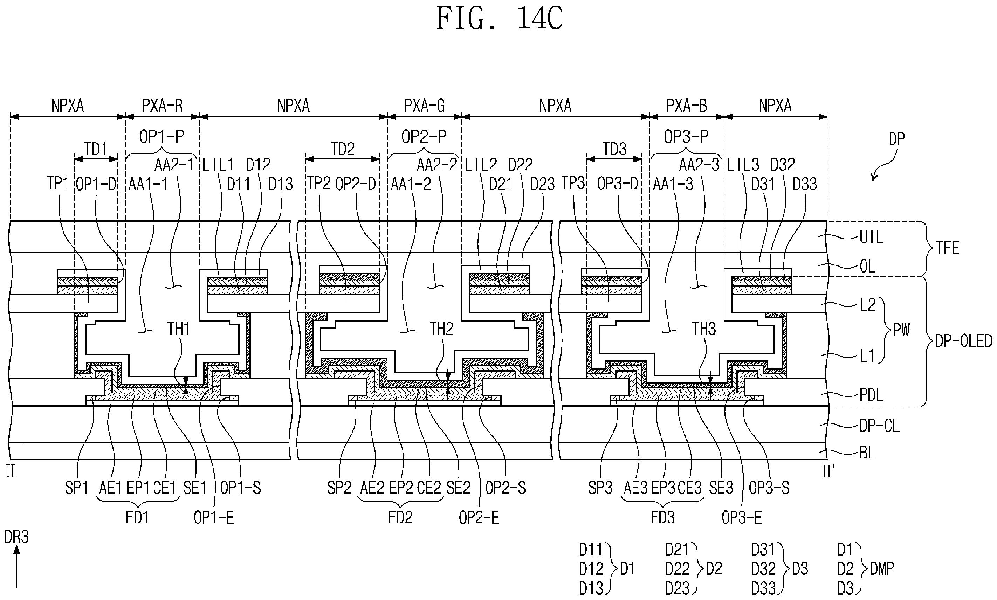

Referring to FIG. 14C, the method may include forming the third lower inorganic encapsulation layer LIL3. Thereafter, the method may include patterning (3-1)th through (3-3)th preliminary dummy layers D31-I, D32-I, and D33-I (refer to FIG. 14B) and the third lower inorganic encapsulation layer LIL3. Detailed processes are performed in the same manner as the processes described herein with reference to FIGS. 12G and 12H, and therefore repeated detailed descriptions with respect to the processes are omitted for brevity.

Thereafter, the method may include forming the organic encapsulation film OL and the upper inorganic encapsulation film UIL, which may complete the display panel DP. The method may include forming the organic encapsulation film OL by applying an organic material using an inkjet method, but is not limited thereto. The organic encapsulation film OL provides a flat upper surface. The method may include forming the upper inorganic encapsulation film UIL by depositing an inorganic material.

According to the present disclosure, respective thicknesses of the first auxiliary electrode through the third auxiliary electrode may be different from one another, and thus the light transmittances of the respective emissive regions may be increased.

In some aspects, according to the present disclosure, the first to third tip portions having protruding lengths proportional to the thicknesses of the first to third auxiliary electrodes may prevent the auxiliary electrodes and the second electrodes in the respective emissive regions from being damaged.

Embodiments of the present disclosure support one or more processes (methods) supportive of the features and embodiments described herein. Descriptions that an element "may be disposed," "may be formed," "may be etched," "may be subjected to patterning," and the like include processes (methods) and techniques for disposing, forming, etching, patterning, and modifying the element (and the like) in accordance with example aspects described herein.

While the present disclosure has been described with reference to embodiments thereof, it will be apparent to those of ordinary skill in the art that various changes and modifications may be made thereto without departing from the scope of the present disclosure as set forth in the following claims.

## Claims

1. A display device comprising:
a base layer (BL) comprising first to third emissive regions (PXA-R, PXA-G, (PXA-B); a pixel defining layer (PDL) disposed on the base layer, wherein first to third light emitting openings (OP1-E, OP2,-E, OP3-E) defined in the pixel defining layer overlap the first to third emissive regions, respectively; a barrier wall (PW) comprising a first barrier wall layer (L1) disposed on the pixel defining layer and a second barrier wall layer (L2) disposed on the first barrier wall layer, wherein first to third barrier wall openings (OP1-P, OP2-P, OP3-P) defined in the barrier wall overlap the first to third light emitting openings, respectively; light emitting elements (ED1, ED2, ED3), each of which comprises a first electrode (AE1, AE2, AE3), an intermediate layer (EP1, EP2, EP3) disposed on the first electrode, and a second electrode (CE1, CE2, CE3) disposed on the intermediate layer;
and **characterized in that**
auxiliary electrodes (SE1, SE2, SE3) disposed on the light emitting elements and covering the second electrodes,
wherein the auxiliary electrodes comprise a first auxiliary electrode overlapping the first light emitting opening and having a first thickness, a second auxiliary electrode overlapping the second light emitting opening and having a second thickness different from the first thickness, and a third auxiliary electrode overlapping the third light emitting opening and having a third thickness different from the first thickness and the second thickness.

2. The display device of claim 1, wherein the second barrier wall layer comprises a first tip portion protruding from the first barrier wall layer toward the first barrier wall opening by a first protruding length, a second tip portion protruding from the first barrier wall layer toward the second barrier wall opening by a second protruding length different from the first protruding length, and a third tip portion protruding from the first barrier wall layer toward the third barrier wall opening by a third protruding length different from the first protruding length and the second protruding length.

3. The display device of claim 2, wherein the first thickness is proportional to the first protruding length, the second thickness is proportional to the second protruding length, and the third thickness is proportional to the third protruding length.

4. The display device of any one of claims 1 to 3, wherein the light emitting elements comprise a first light emitting element overlapping the first light emitting opening, a second light emitting element overlapping the second light emitting opening, and a third light emitting element overlapping the third light emitting opening, and
wherein the first light emitting element emits red light, the second light emitting element emits green light, and the third light emitting element emits blue light.

5. The display device of any one of claims 2 to 4, wherein the third thickness is greater than the first thickness, and the second thickness is greater than the third thickness.

6. The display device of any one of claims 2 to 5, wherein the third protruding length is longer than the first protruding length, and the second protruding length is longer than the third protruding length.

7. The display device of any one of claims 1 to 6, wherein the first thickness ranges from about 255 Å to about 345 Å, the second thickness ranges from about 1020 Å to about 1380 Å, and the third thickness ranges from about 765 Å to about 1035 Å.

8. The display device of any one of claims 2 to 7, wherein the first protruding length ranges from about 0.4 µm to about 0.5 µm, the second protruding length ranges from about 1.5 µm to about 1.8 µm, and the third protruding length ranges from about 1.0 µm to about 1.4 µm.

9. The display device of any one of claims 2 to 8, wherein the first auxiliary electrode does not make contact with at least a portion of a lower surface of the first tip portion, the second auxiliary electrode does not make contact with at least a portion of a lower surface of the second tip portion, and the third auxiliary electrode does not make contact with at least a portion of a lower surface of the third tip portion.

10. The display device of any one of claims 1 to 9, wherein the first to third auxiliary electrodes are electrically connected with the barrier wall and make contact with inner surfaces of the first barrier wall layer, respectively.

11. The display device of any one of claims 1 to 10, wherein each of the first to third auxiliary electrodes comprises indium zinc oxide.

12. The display device of any one of claims 1 to 11, wherein the first thickness is a thickness by which red light transmittance of the first auxiliary electrode is maximal,
wherein the second thickness is a thickness by which green light transmittance of the second auxiliary electrode is maximal, and
wherein the third thickness is a thickness by which blue light transmittance of the third auxiliary electrode is maximal.

13. The display device of any one of claims 1 to 12, wherein a thickness of the second barrier wall layer ranges from about 2500 Å to about 3000 Å.

14. The display device of any one of claims 1 to 13, further comprising:
first to third capping patterns disposed on the first to third auxiliary electrodes and overlapping the first to third light emitting openings, respectively.

15. A method for manufacturing a display device, the method comprising:
providing a preliminary display panel comprising a base layer (BL), a pixel defining layer (PDL) disposed on the base layer, a first preliminary barrier wall layer (L1-I) disposed on the pixel defining layer, and a second preliminary barrier wall layer (L2-I) disposed on the first preliminary barrier wall layer; forming a first barrier wall opening (OP1-P) and a first tip portion (TP1) of the second preliminary barrier wall layer by etching the first preliminary barrier wall layer and the second preliminary barrier wall layer, wherein the first tip portion of the second preliminary barrier wall layer protrudes from the first preliminary barrier wall layer toward the first barrier wall opening; forming a first light emitting element (ED1) and a first auxiliary electrode (SE1) in the first barrier wall opening, wherein the first auxiliary electrode is disposed on the first light emitting element and has a first thickness; forming a second barrier wall opening (OP2-P) and a second tip portion (TP2) of the second preliminary barrier wall layer by etching the first preliminary barrier wall layer and the second preliminary barrier wall layer, wherein the second tip portion of the second preliminary barrier wall layer protrudes from the first preliminary barrier wall layer toward the second barrier wall opening; and forming a second light emitting element (ED2) and a second auxiliary electrode (SE2) in the second barrier wall opening, wherein the second auxiliary electrode is disposed on the second light emitting element and has a second thickness different from the first thickness, wherein the first thickness is proportional to a protruding length of the first tip portion, and the second thickness is proportional to a protruding length of the second tip portion.

## Patentansprüche

1. Anzeigevorrichtung, umfassend:
eine Basisschicht (BL), die erste bis dritte emittierende Bereiche (PXA-R, PXA-G, PXA-B) umfasst; eine auf der Basisschicht angeordnete Pixeldefinitionsschicht (PDL), in der erste bis dritte lichtemittierende Öffnungen (OP1-E, OP2-E, OP3-E), die in der Pixeldefinitionsschicht definiert sind, jeweils die ersten bis dritten emittierenden Bereiche überlappen; eine Barrierewand (PW), die eine erste Barrierewandschicht (L1) umfasst, die auf der Pixeldefinitionsschicht angeordnet ist, und eine zweite Barrierewandschicht (L2), die auf der ersten Barrierewandschicht angeordnet ist, in der erste bis dritte Barrierewandöffnungen (OP1-P, OP2-P, OP3-P), die in der Barrierewand definiert sind, jeweils die ersten bis dritten lichtemittierenden Öffnungen überlappen; lichtemittierende Elemente (ED1, ED2, ED3), von denen jedes eine erste Elektrode (AE1, AE2, AE3), eine auf der ersten Elektrode angeordnete Zwischenschicht (EP1, EP2, EP3) und eine zweite auf der Zwischenschicht angeordnete Elektrode (CE1, CE2, CE3) umfassen;
und **dadurch gekennzeichnet, dass**
Hilfselektroden (SE1, SE2, SE3) auf den lichtemittierenden Elementen angeordnet sind und die zweiten Elektroden bedecken,
wobei die Hilfselektroden eine erste Hilfselektrode umfassen, welche die erste lichtemittierende Öffnung überlappt und eine erste Dicke aufweist, eine zweite Hilfselektrode, welche die zweite lichtemittierende Öffnung überlappt und eine zweite, sich von der ersten Dicke unterscheidende Dicke aufweist, und eine dritte Hilfselektrode, welche die dritte lichtemittierende Öffnung überlappt und eine dritte, sich von der ersten und der zweiten Dicke unterscheidende Dicke aufweist.

2. Anzeigevorrichtung nach Anspruch 1, wobei die zweite Barrierewandschicht einen ersten Spitzenabschnitt umfasst, der aus der ersten Barrierewandschicht um eine erste vorstehende Länge in Richtung der ersten Barrierewandöffnung hervorsteht, einen zweiten Spitzenabschnitt, der von der ersten Barrierewandschicht um eine zweite, sich von der ersten vorstehenden Länge unterscheidenden vorstehenden Länge in Richtung der zweiten Barrierewandöffnung hervorsteht, und einen dritten Spitzenabschnitt, der von der ersten Barrierewandschicht um eine dritte, sich von der ersten und der zweiten vorstehenden Länge unterscheidenden vorstehenden Länge in Richtung der dritten Barrierewandöffnung hervorsteht.

3. Anzeigevorrichtung nach Anspruch 2, wobei die erste Dicke proportional zur ersten vorstehenden Länge, die zweite Dicke proportional zur zweiten vorstehenden Länge, und die dritte Dicke proportional zur dritten vorstehenden Länge ist.

4. Anzeigevorrichtung nach einem der Ansprüche 1 bis 3, wobei die lichtemittierenden Elemente ein erstes lichtemittierendes Element, das die erste lichtemittierende Öffnung überlappt, ein zweites lichtemittierendes Element, das die zweite lichtemittierende Öffnung überlappt, und ein drittes lichtemittierendes Element, das die dritte lichtemittierende Öffnung überlappt, umfassen, und
wobei das erste lichtemittierende Element rotes Licht emittiert, das zweite lichtemittierende Element grünes Licht emittiert und das dritte lichtemittierende Element blaues Licht emittiert.

5. Anzeigevorrichtung nach einem der Ansprüche 2 bis 4, wobei die dritte Dicke größer als die erste Dicke ist und die zweite Dicke größer als die dritte Dicke ist.

6. Anzeigevorrichtung nach einem der Ansprüche 2 bis 5, wobei die dritte vorstehende Länge länger als die erste vorstehende Länge ist und die zweite vorstehende Länge länger als die dritte vorstehende Länge ist.

7. Anzeigevorrichtung nach einem der Ansprüche 1 bis 6, wobei die erste Dicke im Bereich von etwa 255 Å bis etwa 345 Å, die zweite Dicke im Bereich von etwa 1020 Å bis etwa 1380 Å und die dritte Dicke im Bereich von etwa 765 Å bis etwa 1035 Å liegt.

8. Anzeigevorrichtung nach einem der Ansprüche 2 bis 7, wobei die erste vorstehende Länge im Bereich von etwa 0,4 µm bis etwa 0,5 µm, die zweite vorstehende Länge im Bereich von etwa 1,5 µm bis etwa 1,8 µm und die dritte vorstehende Länge im Bereich von etwa 1,0 µm bis etwa 1,4 µm liegt.

9. Anzeigevorrichtung nach einem der Ansprüche 2 bis 8, wobei die erste Hilfselektrode keinen Kontakt mit mindestens einem Abschnitt einer unteren Oberfläche des ersten Spitzenabschnitts aufbaut, die zweite Hilfselektrode keinen Kontakt mit mindestens einem Abschnitt einer unteren Oberfläche des zweiten Spitzenabschnitts aufbaut und die dritte Hilfselektrode keinen Kontakt mit mindestens einem Abschnitt einer unteren Oberfläche des dritten Spitzenabschnitts aufbaut.

10. Anzeigevorrichtung nach einem der Ansprüche 1 bis 9, wobei die erste bis dritte Hilfselektrode elektrisch mit der Barrierewand verbunden sind und jeweils Kontakt mit inneren Oberflächen der ersten Barrierewandschicht aufbauen.

11. Anzeigevorrichtung nach einem der Ansprüche 1 bis 10, wobei jede der ersten bis dritten Hilfselektrode Indiumzinkoxid umfasst.

12. Anzeigevorrichtung nach einem der Ansprüche 1 bis 11, wobei die erste Dicke eine Dicke ist, bei der die Rotlichtdurchlässigkeit der ersten Hilfselektrode maximal ist,
wobei die zweite Dicke eine Dicke ist, bei der die Grünlichtdurchlässigkeit der zweiten Hilfselektrode maximal ist, und
wobei die dritte Dicke eine Dicke ist, bei der die Blaulichtdurchlässigkeit der dritten Hilfselektrode maximal ist.

13. Anzeigevorrichtung nach einem der Ansprüche 1 bis 12, wobei eine Dicke der zweiten Barrierewandschicht im Bereich von etwa 2500 Å bis etwa 3000 Å liegt.

14. Anzeigevorrichtung nach einem der Ansprüche 1 bis 13, weiter umfassend:
erste bis dritte Verschließmuster, die auf der ersten bis dritten Hilfselektrode angeordnet sind und jeweils die erste bis dritte lichtemittierende Öffnung überlappen.

15. Verfahren zur Herstellung einer Anzeigevorrichtung, wobei das Verfahren umfasst:
Bereitstellen eines vorläufigen Anzeigefeldes, umfassend eine Basisschicht (BL), eine auf der Basisschicht angeordnete Pixeldefinitionsschicht (PDL), eine erste vorläufige Barrierewandschicht (L1-I), die auf der Pixeldefinitionsschicht angeordnet ist, und eine zweite vorläufige Barrierewandschicht (L2-I), die auf der ersten vorläufigen Barriereschicht angeordnet ist; Bilden einer ersten Barrierewandöffnung (OP1-P) und eines ersten Spitzenabschnitts (TP1) der zweiten vorläufigen Barrierewandschicht durch Ätzen der ersten vorläufigen Barrierewandschicht und der zweiten vorläufigen Barrierewandschicht, wobei der erste Spitzenabschnitt der zweiten vorläufigen Barrierewandschicht aus der ersten vorläufigen Barrierewandschicht in Richtung der ersten Barrierewandöffnung hervorsteht; Bilden eines ersten lichtemittierenden Elements (ED1) und einer ersten Hilfselektrode (SE1) in der ersten Barrierewandöffnung, wobei die erste Hilfselektrode auf dem ersten lichtemittierenden Element angeordnet ist und eine erste Dicke aufweist; Bilden einer zweiten Barrierewandöffnung (OP2-P) und eines zweiten Spitzenabschnitts (TP2) der zweiten vorläufigen Barrierewandschicht durch Ätzen der ersten vorläufigen Barrierewandschicht und der zweiten vorläufigen Barrierewandschicht, wobei der zweite Spitzenabschnitt der zweiten vorläufigen Barrierewandschicht aus der ersten vorläufigen Barrierewandschicht in Richtung der zweiten Barrierewandöffnung hervorsteht; und Bilden eines zweiten lichtemittierenden Elements (ED2) und einer zweiten Hilfselektrode (SE2) in der zweiten Barrierewandöffnung, wobei die zweite Hilfselektrode auf dem zweiten lichtemittierenden Element angeordnet ist und eine zweite, sich von der ersten Dicke unterscheidende Dicke aufweist, wobei die erste Dicke ist proportional zu einer vorstehenden Länge des ersten Spitzenabschnitts ist, und die zweite Dicke proportional zu einer vorstehenden Länge des zweiten Spitzenabschnitts ist.

## Revendications

1. Dispositif d'affichage, comprenant :
une couche de base (BL) comprenant les trois premières régions émissives (PXA-R, PXA-G, PXA-B) ; une couche de définition de pixels (PDL) disposée sur la couche de base, dans lequel les trois premières ouvertures d'émission de lumière (OP1-E, OP2-E, OP3-E) définies dans la couche de définition de pixels chevauchent respectivement les trois premières régions émissives ; une paroi barrière (PW) comprenant une première couche de paroi barrière (L1) disposée sur la couche de définition de pixels et une deuxième couche de paroi barrière (L2) disposée sur la première, dans lequel les trois premières ouvertures de paroi barrière (OP1-P, OP2-P, OP3-P) définies dans la paroi barrière chevauchent respectivement les trois premières ouvertures d'émission de lumière ; des éléments électroluminescents (ED1, ED2, ED3), chacun comprenant une première électrode (AE1, AE2, AE3), une couche intermédiaire (EP1, EP2, EP3) disposée sur la première électrode et une deuxième électrode (CE1, CE2, CE3) disposée sur la couche intermédiaire ;
et **caractérisé en ce que**
des électrodes auxiliaires (SE1, SE2, SE3) disposées sur les éléments électroluminescents et recouvrant les deuxièmes électrodes,
dans lequel les électrodes auxiliaires comprennent une première électrode auxiliaire recouvrant la première ouverture d'émission de lumière et présentant une première épaisseur, une deuxième électrode auxiliaire recouvrant la deuxième ouverture d'émission de lumière et présentant une deuxième épaisseur différente de la première épaisseur, et une troisième électrode auxiliaire recouvrant la troisième ouverture d'émission de lumière et présentant une troisième épaisseur différente de la première et de la deuxième épaisseur.

2. Dispositif d'affichage selon la revendication 1, dans lequel la deuxième couche de paroi barrière comprend une première partie d'extrémité faisant saillie de la première couche de paroi barrière vers la première ouverture de paroi barrière par une première longueur de saillie, une deuxième partie d'extrémité faisant saillie de la première couche de paroi barrière vers la deuxième ouverture de paroi barrière par une deuxième longueur de saillie différente de la première longueur de saillie, et une troisième partie d'extrémité faisant saillie de la première couche de paroi barrière vers la troisième ouverture de paroi barrière par une troisième longueur de saillie différente de la première et de la deuxième longueur de saillie.

3. Dispositif d'affichage selon la revendication 2, dans lequel la première épaisseur est proportionnelle à la première longueur de saillie, la deuxième épaisseur est proportionnelle à la deuxième longueur de saillie et la troisième épaisseur est proportionnelle à la troisième longueur de saillie.

4. Dispositif d'affichage selon l'une quelconque des revendications 1 à 3, dans lequel les éléments électroluminescents comprennent un premier élément électroluminescent chevauchant la première ouverture d'émission de lumière, un deuxième élément électroluminescent chevauchant la deuxième ouverture d'émission de lumière et un troisième élément électroluminescent chevauchant la troisième ouverture d'émission de lumière, et
dans lequel le premier élément électroluminescent émet de la lumière rouge, le deuxième élément électroluminescent émet de la lumière verte et le troisième élément électroluminescent émet de la lumière bleue.

5. Dispositif d'affichage selon l'une quelconque des revendications 2 à 4, dans lequel la troisième épaisseur est supérieure à la première épaisseur et la deuxième épaisseur est supérieure à la troisième épaisseur.

6. Dispositif d'affichage selon l'une quelconque des revendications 2 à 5, dans lequel la troisième longueur de saillie est plus longue que la première longueur de saillie, et la deuxième longueur de saillie est plus longue que la troisième longueur de saillie.

7. Dispositif d'affichage selon l'une quelconque des revendications 1 à 6, dans lequel la première épaisseur varie d'environ 255 Å à environ 345 Å, la deuxième épaisseur varie d'environ 1020 Å à environ 1380 Å et la troisième épaisseur varie d'environ 765 Å à environ 1035 Å.

8. Dispositif d'affichage selon l'une quelconque des revendications 2 à 7, dans lequel la première longueur de saillie est comprise entre environ 0,4 µm et environ 0,5 µm, la deuxième longueur de saillie est comprise entre environ 1,5 µm et environ 1,8 µm, et la troisième longueur de saillie est comprise entre environ 1,0 µm et environ 1,4 µm.

9. Dispositif d'affichage selon l'une quelconque des revendications 2 à 8, dans lequel la première électrode auxiliaire n'entre pas en contact avec au moins une partie de la surface inférieure de la première partie d'extrémité, la deuxième électrode auxiliaire n'entre pas en contact avec au moins une partie de la surface inférieure de la deuxième partie d'extrémité et la troisième électrode auxiliaire n'entre pas en contact avec au moins une partie de la surface inférieure de la troisième partie d'extrémité.

10. Dispositif d'affichage selon l'une quelconque des revendications 1 à 9, dans lequel les première à troisième électrodes auxiliaires sont respectivement connectées électriquement à la paroi barrière et entrent en contact avec les surfaces internes de la première couche de paroi barrière.

11. Dispositif d'affichage selon l'une quelconque des revendications 1 à 10, dans lequel chacune des première à troisième électrodes auxiliaires comprend de l'oxyde d'indium-zinc.

12. Dispositif d'affichage selon l'une quelconque des revendications 1 à 11, dans lequel la première épaisseur est une épaisseur pour laquelle la transmittance de la lumière rouge de la première électrode auxiliaire est maximale,
dans lequel la deuxième épaisseur est une épaisseur pour laquelle la transmittance de la lumière verte de la deuxième électrode auxiliaire est maximale, et
dans lequel la troisième épaisseur est une épaisseur pour laquelle la transmittance de la lumière bleue de la troisième électrode auxiliaire est maximale.

13. Dispositif d'affichage selon l'une quelconque des revendications 1 à 12, dans lequel une épaisseur de la deuxième couche de paroi barrière varie d'environ 2500 Å à environ 3000 Å.

14. Dispositif d'affichage selon l'une quelconque des revendications 1 à 13, comprenant en outre :
des premier à troisième motifs de recouvrement disposés sur les première à troisième électrodes auxiliaires et chevauchant les première à troisième ouvertures d'émission de lumière, respectivement.

15. Procédé de fabrication d'un dispositif d'affichage, le procédé comprenant :
la fourniture d'un panneau d'affichage préliminaire comprenant une couche de base (BL), une couche de définition de pixels (PDL) disposée sur la couche de base, une première couche de barrière préliminaire (L1-I) disposée sur la couche de définition de pixels et une deuxième couche de barrière préliminaire (L2-I) disposée sur la première couche de barrière préliminaire ; la formation d'une première ouverture de paroi barrière (OP1-P) et une première partie d'extrémité (TP1) de la deuxième couche de barrière préliminaire par gravure de la première couche de paroi barrière préliminaire et de la deuxième couche de paroi barrière préliminaire, dans lequel la première partie d'extrémité de la deuxième couche de paroi barrière préliminaire faisant saillie de la première couche de paroi barrière préliminaire vers la première ouverture de barrière ; la formation d'un premier élément électroluminescent (ED1) et d'une première électrode auxiliaire (SE1) dans la première ouverture de paroi barrière, dans lequel la première électrode auxiliaire est disposée sur le premier élément électroluminescent et présentant une première épaisseur ; la formation d'une deuxième ouverture de paroi barrière (OP2-P) et une deuxième partie d'extrémité (TP2) de la deuxième couche de paroi barrière préliminaire par gravure de la première couche de paroi barrière préliminaire et de la deuxième couche de paroi barrière préliminaire, dans lequel la deuxième partie d'extrémité de la deuxième couche de paroi barrière préliminaire faisant saillie de la première couche de paroi barrière préliminaire vers la deuxième ouverture de paroi barrière ; et la formation d'un deuxième élément électroluminescent (ED2) et d'une deuxième électrode auxiliaire (SE2) dans la deuxième ouverture de paroi barrière, dans lequel la deuxième électrode auxiliaire est disposée sur le deuxième élément électroluminescent et présente une deuxième épaisseur différente de la première, dans lequel la première épaisseur est proportionnelle à la longueur de saillie de la première partie d'extrémité, et la deuxième épaisseur est proportionnelle à la longueur de saillie de la deuxième partie d'extrémité.
